(19) Europäisches Patentamt
European Patent Office
Office européen des brevets

(11) **EP 1 111 345 B1**

(12) **EUROPÄISCHE PATENTSCHRIFT**

(45) Veröffentlichungstag und Bekanntmachung des Hinweises auf die Patenterteilung:
**13.06.2007 Patentblatt 2007/24**

(51) Int Cl.:
*G01D 5/245* $^{(2006.01)}$        *G01D 5/347* $^{(2006.01)}$

(21) Anmeldenummer: **00127426.5**

(22) Anmeldetag: **14.12.2000**

(54) **Positionsmesseinrichtung mit Inkrementalspur mit zwei unterschiedlichen Teilungsperioden**

Position measuring device with incremental track with two different graduation periods

Dispositif de mesure de position avec une piste incrementielle avec deux graduations de période differente

(84) Benannte Vertragsstaaten:
**AT BE CH CY DE DK ES FI FR GB GR IE IT LI LU MC NL PT SE TR**

(30) Priorität: **23.12.1999 DE 19962278**

(43) Veröffentlichungstag der Anmeldung:
**27.06.2001 Patentblatt 2001/26**

(73) Patentinhaber: **Dr. Johannes Heidenhain GmbH 83292 Traunreut (DE)**

(72) Erfinder:
• **Holzapfel, Wolfgang 83119 Obing (DE)**
• **Benner, Ullrich 83308 Trostberg (DE)**

(56) Entgegenhaltungen:
**DE-A- 19 505 176            DE-A- 19 941 318
GB-A- 2 116 313**

**Beschreibung**

Die vorliegende Erfindung betrifft eine Positionsmesseinrichtung, die sich insbesondere zur absoluten Positionsbestimmung eignet.

Eine erste Kategorie bekannter Vorrichtungen zur absoluten Positionsbestimmung umfasst auf der Maßstabseite eine Absolut-Spur zur groben absoluten Positionsbestimmung sowie mehrere Inkremental-Spuren zur höher auflösenden inkrementalen Positionsbestimmung. Im Zusammenhang mit derartigen Messsystemen zur absoluten Positionsbestimmung sei etwa auf die Fig. 6 der US 5,252,825 verwiesen. Zur Absolutpositions-Bestimmung können beispielsweise bekannte serielle Pseudo-Random-Codes eingesetzt werden. Die weiteren Inkremental-Spuren umfassen üblicherweise Inkrementalteilungen mit gegeneinander abgestuften Teilungsperioden, ausgehend von einer groben Inkrementalteilungsperiode bis hin zu einer feinen Inkrementalteilungsperiode. Die feinste Inkrementalteilungsperiode bestimmt letztlich die maximale Auflösung eines derartigen Messsystems. Im Messbetrieb ist eine entsprechende Verarbeitung der Abtastsignale der verschiedenen Spuren erforderlich, um die gewünschte Absolutposition ausgangsseitig zur Verfügung zu haben. Die verschiedenen Spuren erstrecken sich auf dem Maßstab parallel zueinander in Messrichtung; hierbei sind sowohl rotatorische wie auch lineare Messanordnungen auf Basis dieses Prinzips bekannt. Je nach Anzahl der Inkremental-Spuren ist demzufolge eine unterschiedliche Breite des Maßstabes erforderlich. Ebenso sind auf Seiten der gegenüber dem Maßstab in Messrichtung beweglichen Abtasteinheit pro Spur mehrere Detektorelemente erforderlich. Insgesamt resultiert bei einer entsprechend großen Anzahl von Inkremental-Spuren ein voluminöser Aufbau einer derartigen Vorrichtung. Im Fall eines rotatorischen Systems ist etwa ein entsprechend großer Teilscheiben-Durchmesser erforderlich. Unter beengten Einbauverhältnissen ergeben sich daher mitunter Probleme.

Desweiteren können sich Schwierigkeiten ergeben, wenn in den beschriebenen Systemen ein Metallband als Maßstabträger eingesetzt werden. So resultieren Fehlmessungen, falls ein solches Metallband nicht exakt parallel zur Messrichtung ausgerichtet ist und die verschiedenen Teilungsspuren um eine Achse verdreht sind, die senkrecht auf der Teilungsebene steht; in diesem Fall ist die Verarbeitung der Signale aus den verschiedenen Spuren und die Absolutpositionsbestimmung aus diesen Signalen mitunter problematisch.

Ferner erfordert eine Vielzahl von Inkrementalspuren eine große ausgeleuchtete Fläche auf Seiten des Maßstabes, d.h. es liegt pro Flächeneinheit auf dem abgetasteten Maßstab eine relativ geringe Bestrahlungsstärke vor. Als Folge hieraus resultieren Abtastsignale mit kleinen Signal-Amplituden, die entsprechend störanfällig sind.

Eine zweite Kategorie von bekannten Vorrichtungen zur absoluten Positionsbestimmung umfasst hingegen lediglich eine einzige Inkremental-Spur, die parallel benachbart zu einer Absolut-Spur mit einer seriellen Absolutcodierung angeordnet ist. Hierzu sei beispielsweise auf die DE 195 05 176 A1 verwiesen. Bei einer derartigen Variante entfallen zwar die oben erwähnten Probleme im Zusammenhang mit dem Bauvolumen, es ergibt sich jedoch eine deutlich verringerte Auflösung bei der Positionsbestimmung im Vergleich zu den oben diskutierten Systemen. Wird hingegen die Auflösung der Inkremental-Spur und der Absolut-Spur zu unterschiedlich gewählt, so sind insbesondere Probleme bei der Synchronisation der Signale aus den unterschiedlichen Spuren die Folge.

Desweiteren ist auch bei derartigen Systemen die Verwendung von Metallbändern auf der Maßstabseite nicht unproblematisch, da wiederum Fehlmessungen bei der Synchronisation der Signale aus der Inkremental-Spur und der benachbarten Absolutspur im Fall nicht-parallel zur Messrichtung ausgerichteter Metallbänder auftreten können. Grundsätzlich am kritischsten ist hierbei immer die erforderliche Synchronisation der Signale aus der Spur mit der höchsten Auflösung mit den Signalen der Spur mit der nächst-höheren Auflösung. Fehler ergeben sich bei dieser Synchronisation insbesondere dann, wenn eine Verdrehung des Maßstabes um eine Achse vorliegt, die senkrecht zur Maßstaboberfläche orientiert ist. Eine derartige Drehung tritt aber in der Regel entlang von dünnen Metallbändern auf, da diese aufgrund der mangelnden Steifigkeit nicht gerade genug geschnitten werden können.

Die oben diskutierten Probleme treten nunmehr nicht nur bei den beschriebenen Kategorien absoluter Positionsmesseinrichtungen mit einer seriell codierten Absolutspur auf. Ähnliche Probleme liegen etwa auch bei rotatorischen Positionsmesseinrichtungen vor, die neben einer hochauflösenden Inkrementalspur desweiteren eine Inkrementalspur besitzen, die über eine Umdrehung ein Ausgangssignal mit einer einzigen Signalperiode liefert.

Aufgabe der vorliegenden Erfindung ist es daher, eine kompakt bauende Positionsmesseinrichtung anzugeben, die aus der Abtastung einer Inkrementalspur möglichst mehrere Inkrementalsignale unterschiedlicher Auflösung liefert.

Diese Aufgabe wird gelöst durch eine Positionsmesseinrichtung mit den Merkmalen des Anspruches 1.

Vorteilhafte Ausführungsformen der erfindungsgemäßen Positionsmesseinrichtung ergeben sich aus den Maßnahmen, die in den abhängigen Ansprüchen aufgeführt sind.

Die erfindungsgemäße Positionsmesseinrichtung gestattet nunmehr die Erzeugung von mindestens zwei Inkrementalsignalen unterschiedicher Auflösung aus der Abtastung lediglich einer Inkrementalspur.

Eine Variante der erfindungsgemäßen Positionsmesseinrichtung, die insbesondere zur absoluten Positionsbestimmung geeignet ist, umfasst lediglich zwei separate Spuren. Eine der beiden Spuren ist als Absolut-Spur ausgebildet, die bei der Abtastung eine grobe absolute Positionsinformation liefert; die zweite der beiden Spuren, d.h. die Inkremental-Spur umfasst hingegen eine Inkrementalteilung mit mindestens zwei unterschiedlichen Teilungsperioden und liefert bei der Abtastung mindestens zwei separate Inkrementalsignale mit unterschiedlichen Signalperioden. Es lassen sich somit aus einer einzigen Inkremental-Spur zumindest zwei Inkrementalsignale unterschiedlicher Auflösung ableiten, ohne dass das Bauvolumen des Gesamtsystems zu groß wird.

Die erfindungsgemäße Positionsmesseinrichtung erweist sich darüberhinaus als relativ unempfindlich gegenüber eventuellen Verkippungen der Abtasteinheit in Bezug auf den abgetasteten Maßstab. Insbesondere bei der oben diskutierten Kategorie absoluter Positionsmesseinrichtungen ist die oben erwähnte Synchronisation der Signale aus der Spur mit der höchsten Auflösung mit den Signalen der Spur mit der nächst-höheren Auflösung nunmehr weniger kritisch, da diese Signale aus einer einzigen bzw. gemeinsamen Spur gewonnen werden. Dies bedeutet, dass auch Metallbänder als Maßstabträger eingesetzt werden können. Aufgrund dieser Unempfindlichkeit gegenüber Verkippungen, Verdrehungen der Abtasteinheit in Bezug auf den Maßstab resultieren keine extremen Anforderungen an mechanische Komponenten wie Maschinenführungen etc., die in Verbindung mit der erfindungsgemäßen Vorrichtung eingesetzt werden.

Ferner ist zu erwähnen, dass im Fall einer optischen Abtastung aufgrund der geringen lateralen Abmessungen der beiden Spuren ingesamt ein kleineres ausgeleuchtetes Feld zur Signalerzeugung ausreicht. Dies hat wiederum eine höhere Beleuchtungsstärke pro Flächeneinheit und damit eine größere Signalstärke bzw. geringere Störanfälligkeit zur Folge.

Wenngleich nachfolgend Ausführungsformen der erfindungsgemäßen Positionsmesseinrichtung beschrieben werden, die jeweils auf einer optischen bzw. photoelektrischen Abtastung basieren, so sei an dieser Stelle darauf hingewiesen, dass die vorliegende Erfindung selbstverständlich auch in Verbindung mit anderen physikalischen Abtastprinzipien realisierbar ist. Ebenso sei erwähnt, dass die erfindungsgemäße Vorrichtung sowohl als lineare wie auch als rotatorische Positionsmesseinrichtung ausgebildet werden kann.

Ebenso lassen sich neben den nachfolgend detailliert erläuterten Ausführungsbeispielen von absoluten Positionsmesseinrichtungen selbstverständlich auch alternative Positionsmesseinrichtungen realisieren. Denkbar ist etwa ein rotatorisches System mit lediglich einer einzigen Inkrementalspur, dessen Abtastung ein erstes grobes Inkrementalsignal mit einer Signalperiode pro Umdrehung und ein zweites hochauflösendes Inkrementalsignal liefert usw..

Weitere Vorteile sowie Einzelheiten der vorliegenden Erfindung ergeben sich aus der nachfolgenden Beschreibung von Ausführungsbeispielen anhand der beiliegenden Zeichnungen.

Dabei zeigt

Figur 1a   eine schematische Darstellung des Abtaststrahlenganges eines ersten Ausführungsbeispieles der erfindungsgemäßen Positionsmesseinrichtung;

Figur 1b   eine Draufsicht auf den Maßstab aus Figur 1a;

Figur 1c   einen vergrößerten Ausschnitt aus der Figur 1b;

Figur 1d   eine Draufsicht auf die Abtastplatte der Abtasteinheit in der Positionsmesseinrichtung aus Figur 1a;

Figur 1e   eine Ansicht der Detektorebene der Abtasteinheit der Vorrichtung aus Figur 1a;

Figur 1f   einen Teil einer Detektoranordnung aus Figur 1e sowie das damit abgetastete Vernier-Streifenmuster;

Figur 1g   die über eine Inkrementalsignal-Detektoranordnung erfassten Abtastsignale;

Figur 2a   eine schematische Darstellung des Abtaststrahlenganges eines zweiten Ausführungsbeispieles der erfindungsgemäßen Positionsmesseinrichtung;

Figur 2b   eine Draufsicht auf den Maßstab aus Figur 2a;

Figur 2c   eine Draufsicht auf die Abtastplatte der Abtasteinheit in der Positionsmesseinrichtung aus Figur 2a;

Figur 2d   eine schematisierte Ansicht der Detektorebene der Abtasteinheit der Positionsmesseinrichtung aus Figur 2a;

Figur 2e   eine Ansicht eines Teiles der Detektorebene der Abtasteinheit der Positionsmesseinrichtung aus Figur 2a sowie die damit abgetasteten Streifenmuster.

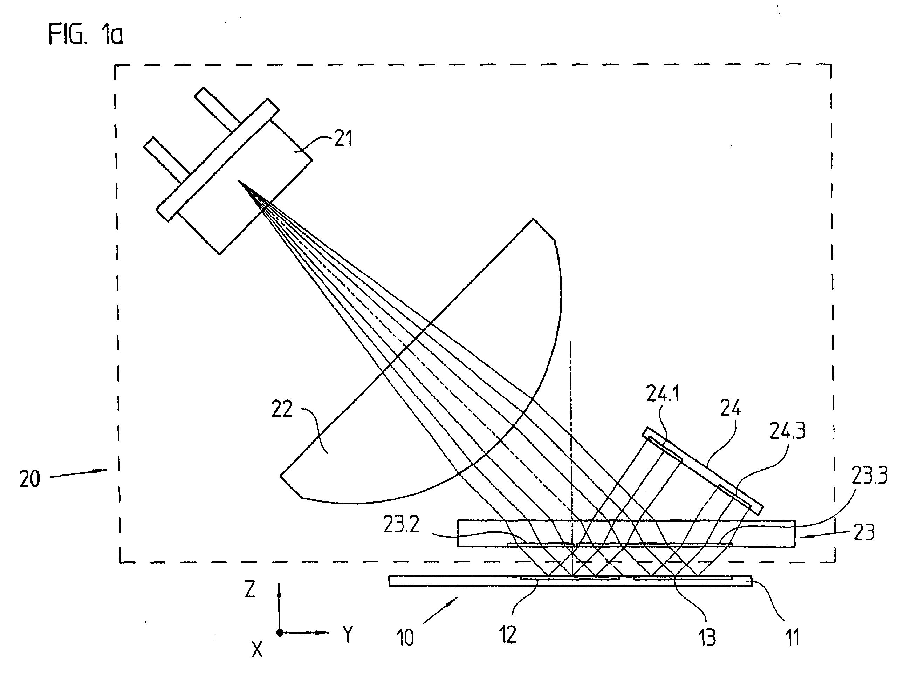

Ein erstes Ausführungsbeispiel der erfindungsgemäßen Positionsmesseinrichtung sei nachfolgend anhand der Figuren 1a - 1g erläutert. Es handelt sich hierbei um eine Vorrichtung zur absoluten Positionsbestimmung.

Figur 1a zeigt hierbei den grundsätzlichen Abtaststrahlengang eines ersten Ausführungsbeispieles der erfindungsgemäßen Positionsmesseinrichtung, die als lineares Auflicht-Messsystem ausgebildet ist. Die Positionsmesseinrichtung umfasst einen Maßstab 10, der sich in Messrichtung x erstreckt, sowie eine gegenüber dem Maßstab 10 in Messrichtung x bewegliche Abtasteinheit 20. Die Messrichtung x ist in der Darstellung der Figur 1a senkrecht zur Zeichenebene orientiert. Maßstab 10 und Abtasteinheit 20 sind beispielsweise mit zueinander beweglichen Maschinenteilen verbunden, deren Position zueinander zu bestimmen ist. Hierbei kann es sich etwa um das Werkzeug und das Werkstück einer numerisch gesteuerten Werkzeugmaschine handeln; die von der erfindungsgemäßen Positionsmesseinrichtung erzeugten Signale werden in diesem Fall von einer - nicht dargestellten - Werkzeugmaschinensteuerung weiterverarbeitet.

Der Maßstab 10 der erfindungsgemäßen Positionsmesseinrichtung umfasst iin dieser Ausführungsform zwei Spuren 12, 13, die auf einem Maßstabträger 11 angeordnet sind und von der Abtasteinheit 20 zur absoluten Positionsbestimmung abgetastet werden. Die beiden Spuren 12, 13 erstrecken sich in Messrichtung x und bestehen in der dargestellten Auflichtvariante der Positionsmesseinrichtung jeweils aus einer Abfolge von Teilbereichen mit unterschiedlichen Reflexionseigenschaften, nämlich aus Teilbereichen hoher Reflektivität und Teilbereichen geringer Reflektivität.

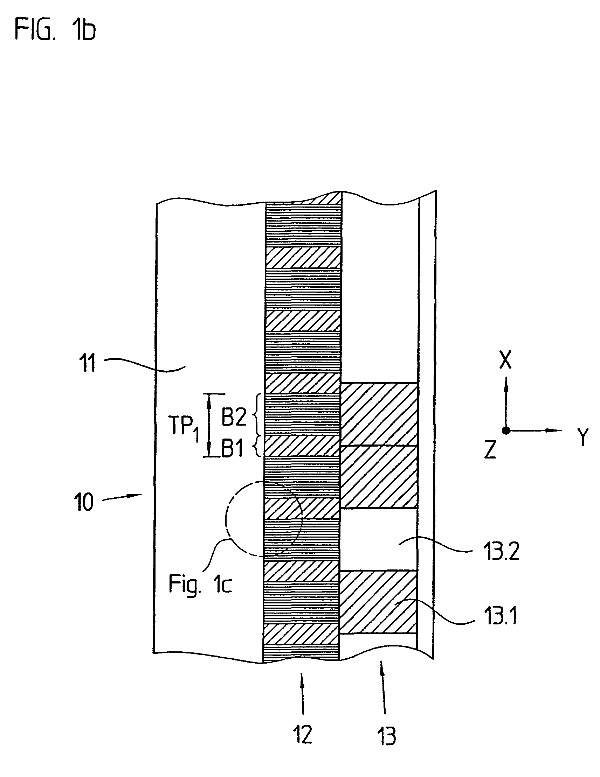

In der Maßstab-Draufsicht der Figur 1b ist die Ausbildung der beiden Spuren 12, 13 des ersten Ausführungsbeispieles erkennbar. Eine erste Spur 13, nachfolgend als Absolutspur 13 bezeichnet, weist eine Absolutcodierung in Form eines Pseudo-Random-Codes auf. Der Pseudo-Random-Code besteht aus einer aperiodischen Abfolge von hochreflektierenden und geringreflektierenden Teilbereichen 13.1, 13.2, die jeweils die gleiche Breite in Messrichtung x besitzen. Aus der Abtastung der Absolutspur 13 kann in bekannter Art und Weise ein grobes Absolutpositionssignal ABS erzeugt werden, dessen Auflösung für die gewünschte hochpräzise Positionsmessung jedoch noch nicht ausreicht. Selbstverständlich können auch alternative serielle Codierungen in der Absolutspur 13 realisiert sein, wie etwa Block-Codes, Manchester-Codes etc..

Unmittelbar benachbart zur Absolut-Spur 13 ist parallel die zweite Spur 12 angeordnet, welche nachfolgend als Inkrementalspur 12 bezeichnet wird. Wie die Absolutspur 13 erstreckt sich die Inkrementalspur 12 ebenfalls in Messrichtung x. Die Inkrementalspur 12 dient zur Erzeugung von höher auflösenden, periodischen Inkrementalsignalen INC1, INC2, die in bekannter Art und Weise zur Bestimmung der Relativposition von Maßstab 10 und Abtasteinheit 20 herangezogen werden. In geeigneter Art und Weise werden in dieser Variante die Inkrementalsignale INC1, INC2 mit den Absolutpositionssignalen ABS der Absolutspur 13 kombiniert, um derart die Absolutposition der zueinander beweglichen Teile zu bestimmen. Hierbei kann die Bestimmung der jeweiligen Absolutposition aus den verschiedenen Abtastsignalen sowohl bereits auf Seiten des Messsystems erfolgen als auch erst in einer nachgeordneten Auswerteeinheit, z.B. einer numerischen Werkzeugmaschinensteuerung.

Im dargestellten Beispiel gestattet die Inkrementalspur 12 erfindungsgemäß die Erzeugung von Inkrementalsignalen INC1, INC2 mit zwei unterschiedlichen Signalperioden $SP_1$, $SP_2$. Hierzu weist die abgetastete Inkrementalspur 12 zwei unterschiedliche Teilungsperioden $TP_1$, $TP_2$ auf. Die Inkremental-spur 12 besteht in diesem Ausführungsbeispiel aus einer periodischen Abfolge von ersten und zweiten Blöcken B1, B2. Durch die Summe der Breiten zweier aufeinanderfolgender Blöcke B1, B2 ist die Teilungsperiode $TP_1$ definiert, die die gröbere der beiden Teilungsperioden $TP_1$, $TP_2$ in der Inkrementalspur 12 darstellt. In dieser Ausführungsform sind die Breiten der beiden Blöcke B1, B2 nicht identisch gewählt; für die Abtastung ist jedoch vor allem die durch die Summe der Breiten definierte grobe Teilungsperiode $TP_1$ von Bedeutung. So kann es je nach Art der Abtastung der Inkrementalspur 12 auch vorteilhaft sein, die Blöcke B1, B2 gleich breit auszubilden.

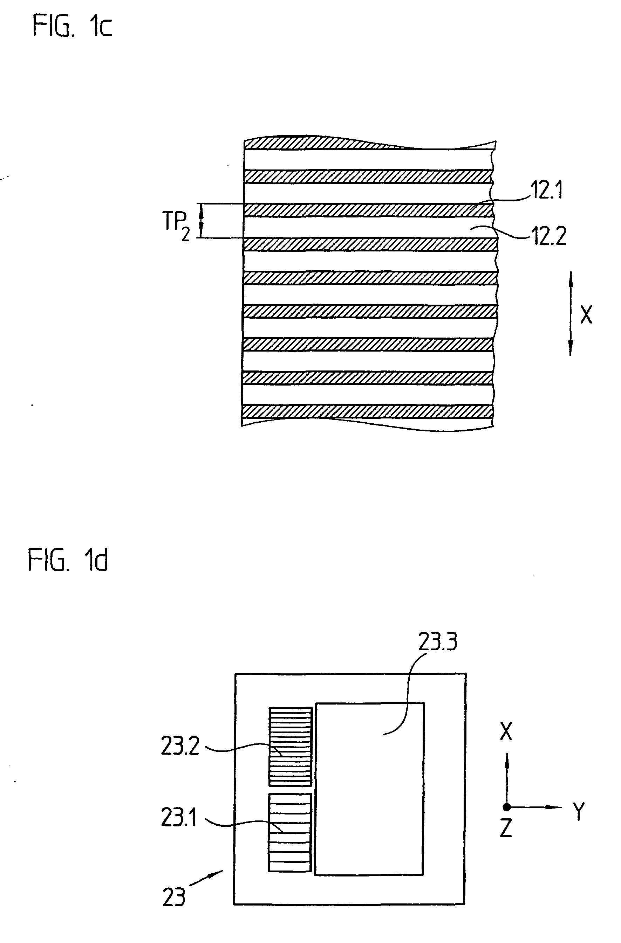

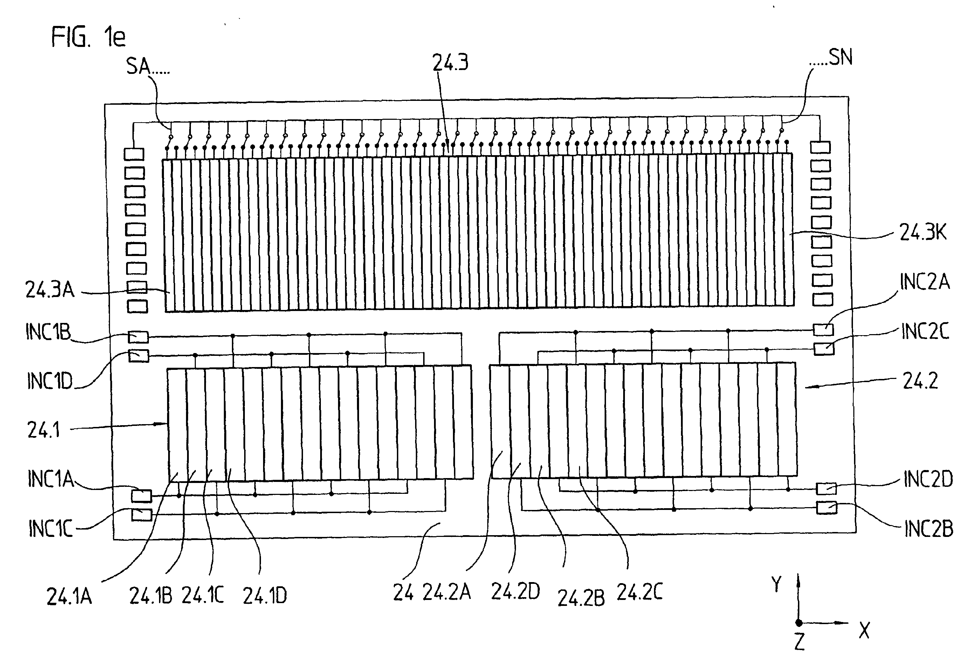

Die ersten Blöcke B1 sind in der dargestellten Variante geringreflektierend ausgebildet; die zweiten Blöcke B2 bestehen hingegen aus einer periodischen Abfolge von weiteren Teilbereichen 12.1, 12.2 mit gering- und hochreflektierenden optischen Eigenschaften. Eine vergrößerte Ausschnittsdarstellung eines zweiten Blokkes B2 ist in Figur 1c dargestellt. Wie aus Figur 1c erkennbar ist, sind die Teilbereiche 12.1, 12.2 in den zweiten Blöcken B2 als schmale reckteckförmige Bereiche ausgebildet, deren Längsachsen sich in y-Richtung in der Maßstabebene erstrecken, d.h. senkrecht zur Messrichtung x orientiert sind. Die verschiedenen Teilbereiche 12.1, 12.2 in den zweiten Blöcken B2 weisen jeweils die gleichen Dimensionen auf. Über die Summe der Breiten zweier aufeinanderfolgender Teilbereiche 12.1, 12.2 in den ersten Blöcken B1 ist die feine Teilungsperiode $TP_2$ der Inkrementalspur 12 definiert, wie dies ebenfalls in Figur 1c veranschaulicht ist.

In der dargestellten Ausführungsform der erfindungsgemäßen Positionsmesseinrichtung ist die feine Teilungsperiode $TP_2$ der Inkrementalspur 12 um den Faktor 10 kleiner gewählt als die gröbere Teilungsperiode $TP_1$ der Inkrementalspur 12, d.h. $TP_1$ = 200 μm und $TP_2$ = 20 μm.

Grundsätzlich sollte die gröbere Teilungsperiode $TP_1$ der Inkrementalspur 12 als ganzzahliges Vielfaches der feineren Teilungsperiode $TP_2$ gewählt $TP_2$ werden. Nur so ist gewährleistet, dass aufeinanderfolgende Blöcke B2 Teile einer durchgehenden Inkrementalteilung mit der feineren Teilungsperiode $TP_2$ darstellen. Es muss demzufolge sichergestellt sein, dass über die gesamte Messlänge hinweg stets geringreflektierende Teilbereiche 12.1 und hochreflektierende Teilbereiche 12.2 alternierend angeordnet sind; insbesondere auch dann, wenn die Inkrementalteilung mit der feineren Teilungsperiode $TP_2$ durch die geringreflektierenden

Blöcke B1 unterbrochen wird. So folgt etwa auf einen geringreflektierenden Teilbereich 12.1 am Rand eines Blockes B2 im unmittelbar in Messrichtung benachbarten Block B2 ein hochreflektierender Teilbereich 12.2 usw.. Die Darstellung der Inkremental-spur 12 in Figur 1b zeigt dies im übrigen nicht im Detail.

Auf die gröbere Teilungsperiode $TP_1$ der Inkrementalteilung 12 ist in diesem Ausführungsbeispiel ferner die Bitbreite des Pseudo-Random Codes der Absolutspur 13 abgestimmt. Dies bedeutet, dass die Breite der Teilbereiche 13.1, 13.2 in der Absolutspur 13 in Messrichtung x identisch zur Teilungsperiode $TP_1$ der Inkrementalspur 12 gewählt ist.

Alternativ zur erläuterten Ausführung des Maßstabes 10 ist es natürlich möglich, die verschiedenen Teilbereiche der beiden Spuren 12, 13 auf dem Maßstabträger 11 mit anderen optischen Eigenschaften auszubilden, also etwa hoch- und geringreflektierende Teilbereiche zu vertauschen. Ebenso kann die erläuterte Ausbildung eines Maßstabes auch auf ein Durchlichtsystem übertragen werden; in diesem Fall wären dann die jeweiligen Teilbereiche in den beiden Spuren durchlässig und undurchlässig auszubilden. Darüberhinaus kann grundsätzlich auch vorgesehen werden, die Inkrementalspur derart auszubilden, dass daraus mehr als zwei Inkrementalsignale mit verschiedenen Signalperioden gewonnen werden usw..

Die in Figur 1a desweiteren schematisch dargestellte Abtasteinheit 20 umfasst eine Lichtquelle 21, z.B. eine LED, eine Kollimatoroptik 22, eine Abtastplatte 23 sowie eine Detektoreinheit 24 zur Erfassung der verschiedenen Abtastsignale. Nachfolgend seien die Abtaststrahlengänge zur Erzeugung der Inkrementalsignale INC1, INC2 sowie der Absolutpositionssignale ABS separat erläutert.

Die von der Lichtquelle 21 emittierten Strahlenbündel, die zur Erzeugung der verschiedenen Inkrementalsignale beitragen, gelangen im dargestelten ersten Beispiel nach der Kollimation über die Kollimatoroptik 22 auf die beiden Abtastteilungen 23.1, 23.2 in der Abtastplatte 23. Eine Ansicht der Abtastplatte 23 ist in Draufsicht in Figur 1d dargestellt. Die beiden Abtastteilungen 23.1, 23.2 weisen unterschiedliche Abtastteilungsperioden $ATP_1$, $ATP_2$ auf, die auf die beiden Teilungsperioden $TP_1$, $TP_2$ der Inkrementalspur 12 abgestimmt sind. Die erste Abtastteilung 23.1 ist hierbei auf die gröbere Teilungsperiode $TP_1$ abgestimmt und dient zur Erzeugung der Inkrementalsignale INC1 mit der gröberen Signalperiode $SP_1$; in einer möglichen Ausführungsform wird die entsprechende Abtastteilungsperiode $ATP_1$ geringfügig unterschiedlich zur gröberen Teilungsperiode $TP_1 = 200\mu m$ gewählt. Die Abtastteilungsperiode $ATP_2$ der zweiten Abtastteilung 23.2 in der Abtastplatte 23 hingegen ist auf die feinere Teilungsperiode $TP_2$ in der Inkrementalspur 12 abgestimmt und und dient zur Erzeugung der Inkrementalsignale INC2 mit der feineren Signalperiode $SP_2$; die Abtastteilungsperiode $ATP_2$ der zweiten Abtastteilung 23.2 wird geringfügig unterschiedlich zur feineren Teilungsperiode $TP_2 = 20\mu m$ gewählt.

Die erste Abtastteilung 23.1 mit der gröberen Abtastteilungsperiode $ATP_1$ ist als reines Amplitudengitter ausgebildet; Die zweite Abtastteilung 23.2 mit der feineren Abtastteilungsperiode $ATP_2$ hingegen ist als kombiniertes Phasen-/Amplitudengitter ausgebildet, wie es in der deutschen Patentanmeldung Nr. 199 41 318.5 beschrieben ist. Eine derartige Ausbildung der zweiten Abtastteilung 23.2 stellt sicher, dass eine bestimmte Invarianz des Messsystems gegen eventuelle Schwankungen des Abtastabstandes gewährleistet ist.

Nach dem Durchlaufen der beiden Abtastteilungen 23.1, 23.2 treffen die jeweiligen Strahlenbündel auf die Inkrementalspur 12 auf dem Maßstab 10 und werden von dort wieder in Richtung der Abtastplatte 23 zurückreflektiert. In der Abtastplatte 23 laufen die zurückreflektierten Strahlenbündel durch einen transparenten Fensterbereich 23.3, ehe sie auf die jeweiligen Inkrementalsignal-Detektoranordnungen 24.1, 24.2 in der Detektoreinheit 24 auftreffen. In Figur 1a ist lediglich eine der beiden Inkrementalsignal-Detektoranordnungen 24.1, 24.2 dieses Ausführungsbeispieles erkennbar, weshalb in Bezug auf den konkreten Aufbau der Detektoreinheit 24 auf die schematisiert dargestellte Draufsicht auf die Detektorebene in Figur 1e verwiesen sei. Wie dort ersichtlich, ist auf Seiten der Detektoreinheit 24 eine erste Inkrementalsignal-Detektoranordnung 24.1 zur Erzeugung der Inkrementalsignale INC1 mit der groben Signalperiode $SP_1$ sowie eine zweite Inkrementalsignal-Detektoranordnung 24.2 zur Erzeugung der Inkrementalsignale INC2 mit der feinen Signalperiode $SP_2$ vorgesehen. Selbstverständlich wird ausgangsseitig je ein Paar von Inkrementalsignalen INC1, INC2 mit grober und feiner Signalperiode $SP_1$, $SP_2$ erzeugt, wobei diese jeweils um 90° phasenversetzt zueinander sind. In Bezug auf den detaillierten Aufbau der Detektoreinheit 24 sei auf die noch folgende detaillierte Beschreibung der Figur 1e verwiesen.

Diejenigen Strahlenbündel, die in diesem Beispiel zur Erzeugung der groben Absolutpositionssignale ABS genutzt werden, durchtreten nach der Kollimation über die Kollimatoroptik 22 den durchlässigen Fensterbereich 23.3 der Abtastplatte 23 und gelangen auf die Absolutspur 13 auf dem Maßstab 10. Von dort erfolgt eine Rückreflexion in Richtung der Abtastplatte 23, wo die reflektierten Strahlenbündel den transparenten Fensterbereich 23.3 nochmals passieren, ehe diese auf die Absolutpositionssignal-Detektoranordnung 24.3 in der Detektoreinheit 24 auftreffen. Über diesen Strahlengang erfolgt demzufolge in bekannter Art und Weise lediglich eine Abbildung bzw. Schattenprojektion des jeweils gerade erfassten Abschnittes des Pseudo-Random-Codes auf die Absolutpositionssignal-Detektoranordnung 24.3.

Eine Ansicht der Detektorebene der Detektoreinheit 24 ist in schematischer Form in Figur 1e dargestellt. Im oberen Teil ist hierbei die Absolutpositionssignal-Detektoranordnung 24.3 erkennbar, die aus einer Vielzahl einzelner optoelektronischer Detektorelemente 24.3A - 24.3K besteht, die in Messrichtung x aufeinanderfolgend angeordnet werden. Je zwei benachbarte Detektorelemente dienen im dargestellten Ausführungsbeispiel zur Abtastung eines Bits des Pseudo-Random-Codes in der Absolutspur 13, d.h. es existieren zwei Gruppen von Detektorelementen 24.3A - 24.3K, welche zum Abtasten der Bits des Pseudo-Random-Codes genutzt werden. Im Messbetrieb wird allerdings nur jeweils eines der beiden Detektorelemente 24.3A - 24.3K pro Bit ausgelesen, was in Figur 1e über die schematisch angedeuteten Schaltelemente SA - SN über den Detektorelementen 24.3A - 24.3K veranschaulicht werden soll. Im vorliegenden Ausführungsbeispiel ist somit zwei Detektorelementen 24.3A - 24.3K, die einer Bitbreite zugeordnet sind, wiederum ein derartiges Schaltelement SA - SN zugeordnet. Hierbei erfolgt das selektive Auslesen des jeweiligen Detektorelementes in Abhängigkeit davon, welche der beiden Gruppen von Detektorelementen 24.3A - 24.3K näher in der Mitte der jeweiligen Bitfelder des Pseudo-Random-Codes liegt. Um dies zu entscheiden wird im Messbetrieb das Inkrementalsignal INC1 mit der gröberen Signalperiode $SP_1$ herangezogen.

Die in den Detektorelementen 24.3A - 24.3K der Absolutpositionssignal-Detektoranordnung 24.3 erzeugten Abtastsignale werden jeweils - nicht dargestellten - Triggerelementen zugeführt, die ausgangsseitig Signale mit logischen HIGH- und LOW-Pegeln liefern, welche zur absoluten Positionsbestimmung weiterverarbeitet werden. Vorzugsweise sind die Triggerelemente in integrierter Form ebenfalls auf dem Trägersubstrat der Detektoreinheit 24 angeordnet. Zur Erzeugung der Ausgangssignale liegt an den Trigger-Elementen desweiteren ein Referenzsignal an, das entweder einen konstanten Signalpegel aufweist oder aber in bekannter Art und Weise in Abhängigkeit des Signalpegels der Abtastsignale variiert wird. Die Ausgangsignale der Triggerelemente werden einer ebenfalls nicht dargestellten Signalverarbeitungseinheit zugeführt, die diese als auch die erzeugten Inkrementalssignale weiterverarbeitet und ein Ausgangssignal ABS erzeugt, das die gewünschte grobe Absolutposition angibt.

Im unteren Teil der Ansicht der Detektoreinheit 24 in Figur 1e sind die beiden Inkrementalsignal-Detektoranordnungen 24.1, 24.2 erkennbar, die in diesem Ausführungsbeispiel zur Abtastung der Inkrementalspur und zur Erzeugung der Inkrementalsignale INC1, INC2 mit den Signalperioden $SP_1$, $SP_2$ dienen. Die in Figur 1e links angeordnete Inkrementalsignal-Detektoranordnung 24.1 dient zur Erzeugung des gröberen Inkrementalsignales INC1 während die rechts angeordnete Inkrementalsignal-Detektoranordnung 24.2 zur Erzeugung des feineren Inkrementalsignales INC2 herangezogen wird.

Prinzipiell weisen beide Inkrementalsignal-Detektoranordnungen 24.1, 24.2 einen vergleichbaren Aufbau auf und sind jeweils als sog. strukturierte Detektoranordnungen bzw. Detektorelement-Arrays ausgebildet. Diese bestehen in bekannter Art und Weise aus einer Vielzahl einzelner optoelektronischer Detektorelemente 24.1A, 24.1B,..., 24.2A, 24.2B,..., die innerhalb einer Inkrementalsignal-Detektoranordnung 24.1, 24.2 allesamt identisch ausgebildet und in Messrichtung x benachbart zueinander angeordnet sind. Diejenigen Detektorelemente 24.1A, 24.1B,..., 24.2A, 24.2B,... einer Detektoranordnung 24.1, 24.2 sind jeweils ausgangsseitig miteinander verschaltet, die phasengleiche Abtastsignale liefern. In der gezeigten Ausführungsform wird in den beiden Detektoranordnungen 24.1, 24.2 jedes fünfte Detektorelement miteinander verschaltet, so dass pro Detektoranordnung 24.1, 24.2 ausgangsseitig insgesamt vier um jeweils 90° phasenversetzte Teil-Inkrementalsignale $INC1_A$, $INC1_B$, $INC1_C$, $INC1_D$, $INC2_A$, $INC2_B$, $INC2_C$, $INC2_D$ vorliegen; diese werden zur Erzeugung der beiden um 90° phasenversetzten Inkrementalsignale $INC1_0$, $INC1_{90}$ bzw. $INC2_0$, $INC2_{90}$ noch in bekannter Art und Weise miteinander in Differenz verschaltet, was in Figur 1e nicht dargestellt ist, so dass pro Detektoranordnung 24.1, 24.2 je ein Paar von um 90° phasenversetzten Inkrementalsignalen resultiert; der Einfachheit halber wurde oben jeweils nur von einem Inkrementalsignal INC1, INC2 gesprochen, ebenso erfolgt dies im weiteren Verlauf der Beschreibung.

In der Detektionsebene liegen im Bereich der beiden Inkrementalsignal-Detektoranordnungen 24.1, 24.2 jeweils periodische Streifenmuster vor, die aus der Wechselwirkung der von der Lichtquelle 21 emittierten Strahlenbündel mit der Inkrementalspur 12 sowie mit den jeweiligen Abtastteilungen 23.1, 23.2 in der Abtastplatte 23 resultieren. Aufgrund der geringfügig unterschiedlichen Teilungsperioden $TP_1$ und $ATP_1$ bzw. $TP_2$ und $ATP_2$ sind die Perioden der jeweils zugehörigen Streifenmuster deutlich größer als $TP_1$ und $TP_2$.

Nachfolgend seien diese Streifenmuster als Vernier-Streifenmuster bezeichnet. Die resultierenden Vernier-Streifenmuster sind wie die Teilungsstrukturen in der Inkrementalspur 12 bzw. in den Abtastteilungen 23.1, 23.2 orientiert. Im Fall der Relativbewegung von Maßstab 10 und Abtasteinheit 20 wandern die derart erzeugten Vernier-Streifenmuster in Messrichtung x über die jeweiligen Inkrementalsignal-Detektoranordnungen 24.1, 24.2, welche dann die verschiebungsabhängig modulierten Inkrementalsignale INC1, INC2 liefern. Aufgrund der Dimensionierung der Abtastteilungen 23.1, 23.2 laufen die Vernier-Streifenmuster im Fall der Relativbewegung von Maßstab 10 und Abtasteinheit 20 unterschiedlich schnell über die jeweiligen Inkrementalsignal-Detektoranordnungen 24.1, 24.2. Es liegen an den verschiedenen Detektoranordnungen 24.1, 24.2 demzufolge periodische Inkrementalsignale INC1, INC2 mit unterschiedlichen Signalperioden $SP_1$, $SP_2$ vor, die sich in diesem Beispiel etwa um den Faktor 10 unterscheiden.

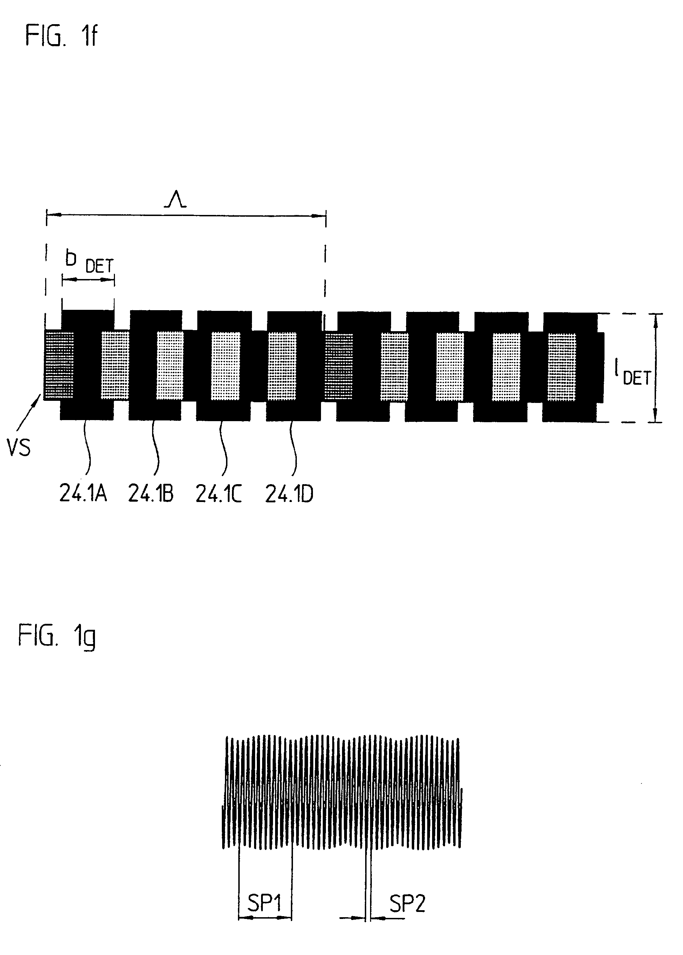

Aufgrund der in dieser Ausführungsform gewählten Dimensionierung der Abtastteilungen 23.1, 23.2, die wie oben erläutert auf die beiden Inkrementalspur-Teilungsperioden TP1, TP2 abgestimmt sind, ergeben sich auf den beiden Inkrementalsignal-Detektoranordnungen 24.1, 24.2 Vernier-Streifenmuster mit gleicher Periodizität. Die Periode der auf beiden Inkrementalsignal-Detektoranordnungen 24.1, 24.2 identischen Vernier-Streifenmuster wird nachfolgend mit $\Lambda$ bezeichnet; in Figur 1f ist das resultierende Vernier-Streifenmuster VS in Verbindung mit einem Ausschnitt der Inkrementalsignal-Detektoranordnung 24.1 gezeigt.

Grundsätzlich könnten durch eine geeignete Dimensionierung der Abtastteilungen 23.1, 23.2 in der Abtastplatte 23 auch Vernier-Streifenmuster auf den beiden Inkrementalsignal-Detektoranordnungen 24.1, 24.2 erzeugt werden, die unterschiedliche Vernier-Perioden $\Lambda$ aufweisen. Die Erzeugung gleicher Vernier-Perioden $\Lambda$ bietet jedoch bestimmte Vorteile. So können dann etwa Inkrementalsignal-Detektoranordnungen 24.1, 24.2 für die groben und feinen Inkrementalsignale verwendet werden, die identisch ausgebildet sind.

Das in Figur 1f dargestellte Vernier-Streifenmuster VS resultiert letztlich aus der gewählten Ausgestaltung der Inkrementalspur 12 auf dem Maßstab 10 und stellt die Überlagerung eines resultierenden reinen Vernier-Streifenmusters aus der Abtastung der feinen Teilungsperiode $TP_2$ und eines Schattenwurf-Musters aus der Abtastung der groben Teilungsperiode $TP_1$ dar.

Um aus den Vernier-Streifenmustern VS auf den beiden Inkrementalsignal-Detektoranordnungen 24.1, 24.2 erfindungsgemäß die gewünschten Inkrementalsignale INC1, INC2 mit unterschiedlichen Signalperioden $SP_1$, $SP_2$ zu gewinnen, sind eine Reihe weiterer Maßnahmen auf Seiten der erfindungsgemäßen Vorrichtung vorgesehen. Diese - nachfolgend erläuterten - Maßnahmen dienen u.a. der Filterung von Signalanteilen mit der Periodizität $SP_2$ im Inkrementalsignal INC1 und von Signalanteilen mit der Periodizität $SP_1$ im Inkrementalsignal INC2. Das heißt, dass über diese Maßnahmen gewährleistet wird, dass die einzelnen Inkrementalsignale INC1, INC2 ohne Beeinflussung durch das jeweils andere Signal erzeugt werden; die entsprechend unerwünschten Signalanteile werden geeignet gefiltert.

So sind in diesem Ausführungsbeispiel Maßnahmen auf Seiten der Abtastteilung 23.1 vorgesehen, die eine Filterung unerwünschter Signalanteile am groben Inkrementalsignal INC1 bewirken. Derartige Signalanteile können etwa aus der gleichzeitigen Abtastung der feineren Teilungsperiode $TP_2$ resultieren und das Inkrementalsignal INC1 stören. Nachteilig ist eine derartige Störung insbesondere dann, wenn das grobe Inkrementalsignal INC1 nachfolgend noch weiter unterteilt bzw. interpoliert werden soll, wozu in der Regel eine möglichst optimale, d.h. sinus- oder cosinusförmige Form der Abtastsignale vorausgesetzt wird. Für eine derartige Filterung ist vorgesehen, dass die als Amplitudengitter ausgebildete Abtastteilung 23.1 mit Filtereigenschaften versehen ist. Hierzu werden bekannte Filterungsmaßnahmen eingesetzt und beispielsweise die transparenten Teilbereiche der Abastteilung 23.1 mit cosinusförmigen Öffnungen ausgestaltet, wie dies z.B. aus der GB 2 116 313 A bekannt ist. Alternativ hierzu ließe sich die Filterung des Oberwellenanteiles mit der Periodizität $SP_2$ auch in bekannter Art und Weise durch geeignete Stegverschiebungen auf Seiten der Abtastteilung 23.1 sicherstellen, d.h. für die Filterung dieses Signalanteiles stehen verschiedene bekannte Maßnahmen zur Verfügung.

Um eine möglichst störungsfreie Erzeugung der Inkrementalsignale INC2 mit der feineren Signalperiode $SP_2$ sicherzustellen sind vorteilhafterweise weitere Dimensionierungsregeln zu beachten,.

So wird die Breite $b_{DET}$ eines einzelnen Detektorelementes 24.2A, 24.2B.... in der Detektoranordnung 24.2, die zur Erzeugung des Inkrementalsignales INC2 mit der feineren Signalperiode SP2 eingesetzt wird, gemäß der Beziehung

$$b_{DET} = n * TP_1$$

gewählt, mit n = 1, 2, 3....

Dies bedeutet, dass die Breite $b_{DET}$ eines einzelnen Detektorelementes 24.2A, 24.2B.... dieser Detektoranordnung letztlich als ganzzahliges Vielfaches der groben Teilungsperiode $TP_1$ in der Inkrementalspur gewählt wird, im vorliegenden Beispiel gilt n = 1. Durch diese Dimensionierungsregel ist sichergestellt, dass bei der Erzeugung des feinen Inkrementalsignales INC2 mit Hilfe der Inkrementalsignal-Detektoranordnung 24.2 eventuelle Offset-Schwankungen mit der Periodizität $SP_1$ verhindert werden.

Im vorliegenden Ausführungsbeispiel sind im übrigen die Detektorelemente 24.1A, 24.1B,.... der Detektoranordnung 24.1 zur Erzeugung des Inkrementalsignales INC1 mit der groben Signalperiode $SP_1$ ebenfalls derart breit ausgebildet; dies ist jedoch nicht grundsätzlich erforderlich.

Ferner liefert im Fall der Relativbewegung von Maßstab und Abtasteinheit ohne weitere Maßnahmen die Inkrementalsignal-Detektoranordnung 24.2 Inkrementalsignale INC2 mit der feinen Signalperiode $SP_2$, welche jedoch in ihrer Amplitude mit der groben Signalperiode $SP_1$ moduliert sind.

Eine Darstellung eines derartigen Inkrementalsignales ist in Figur 1g gezeigt. Für eine zuverlässige Weiterverarbeitung der feinen Inkrementalsignale INC2 ist jedoch eine möglichst gleichbleibende Amplitude dieser Signale vorteilhaft. Um dies sicherzustellen wird deshalb deshalb vorzugsweise die Vernier-Periode $\Lambda$ des Vernier-Streifenmusters VS nach der Beziehung

$$\Lambda = (2 * m + 1) * TP_1 \qquad \text{Gl.}$$

gewählt, mit m = 1, 2, 3.....

Zudem wäre in diesem Fall auch die Breite der Blöcke B1 und B2 in der Inkrementalspur entgegen dem Beispiel in Figur 1b in der Messrichtung x identisch zu wählen.

Im vorliegenden Beispiel wurde m = 2 gewählt, woraus mit $TP_1 = 200\mu m$ eine erforderliche Vernier-Periode $\Lambda = 1mm$ in der Detektionsebene resultiert. Grundsätzlich lässt sich die erforderliche Vernier-Periode $\Lambda$ durch die Wahl der verschiedenen Teilungsperioden auf Seiten des Maßstabes und der Abtastteilungen definiert einstellen.

Durch diese Wahl der Vernier-Periode $\Lambda$ und die Gegentaktverschaltung bzw. Differenzverschaltung derjenigen Detektorelemente, die Ausgangssignale einen relativen Phasenversatz von 180° aufweisen, lässt sich die oben erwähnte, unerwünschte Amplitudenmodulation des feinen Inkrementalsignales INC2 eliminieren. Über die Gegentaktverschaltung erfolgt hierbei letztlich die Bildung der Differenz aus den jeweiligen Teil-Inkrementalsignalen, die aus invers ausgestalteten Bereichen der groben Teilungsperiode $TP_1$ der Inkrementalspur 12 stammen. Die unerwünschten Amplitudenmodulationen der Teil-Inkrementalsignale heben sich dann gegenseitig auf. Ausgangsseitig liegen dann Inkrementalsignale mit gleichbleibender Amplitude vor.

Desweiteren können auch unerwünschte Oberwellenanteile am feiner auflösenden Inkrementalsignal INC2 durch bekannte Filterungsmaßnahmen eliminiert oder zumindest minimiert werden; derartige Filterungsmaßnahmen sind hierbei entweder auf Seiten der Abtastteilung 23.2 oder aber auf Seiten der Detektoranordnung 24.2 vorzusehen.

Die diskutierten Maßnahmen stellen nunmehr sicher, dass aus der Abtastung der Inkrementalspur 12 zuverlässig die Inkrementalsignale INC1, INC2 mit verschiedenen Signalperioden $SP_1$, $SP_2$ gewonnen werden können. Durch die Kombination mit dem groben Absolutpositionssignal ABS aus der Absolutspur 13 lässt sich in dieser Ausführungsform der erfindungsgemäßen Positionsmesseinrichtung in bekannter Art und Weise die hochauflösende absolute Positionsbestimmung sicherstellen.

Wie bereits oben angedeutet können die verschiedenen Abtastsignale bereits auf Seiten der erfindungsgemäßen Vorrichtung geeignet miteinander verrechnet bzw. kombiniert werden, um die jeweils aktuelle Absolutposition präzise zu bestimmen; ebenso ist es aber auch möglich, die verschiedenen Abtastsignale an eine nachgeordnete Auswerteeinheit zu übertragen, wo die Bestimmung der Absolutposition aus diesen Signalen erfolgt usw..

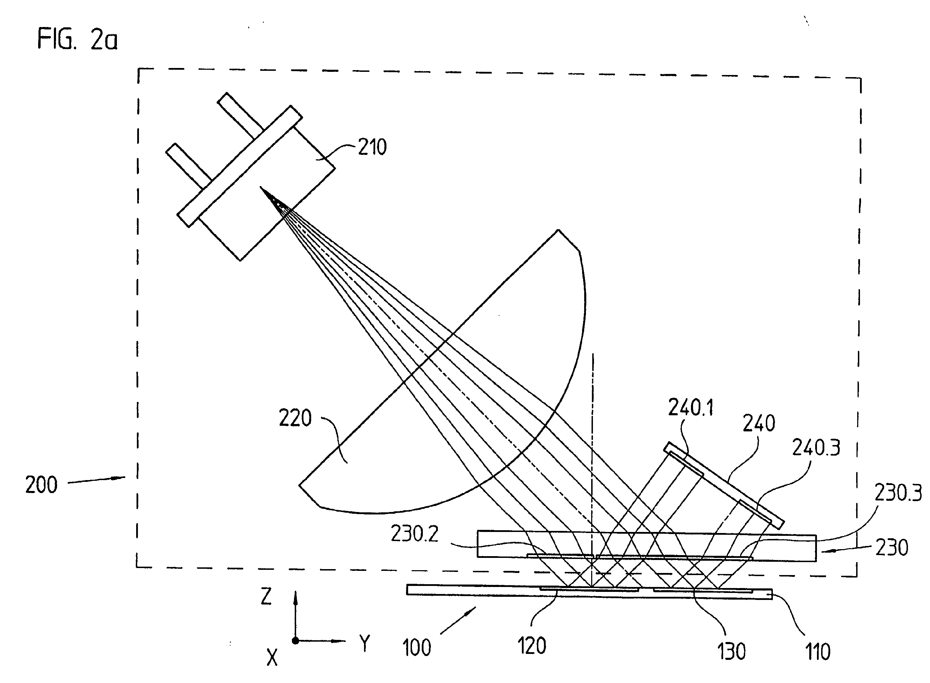

Eine zweite Ausführungsform der erfindungsgemäßen Vorrichtung sei nachfolgend anhand der Figuren 2a - 2e erläutert. Hierbei wird in der Beschreibung dieses Beispiels lediglich auf die wesentlichen Unterschiede zur ersten Ausführungsform eingegangen, d.h. identische Komponenten der Vorrichtung haben i.w. die identischen Funktionen, sofern nachfolgend nicht eventuelle Unterschiede erläutert werden. Auch bei dieser Ausführungsform der erfindungsgemäßen Positionsmesseinrichtung handelt es sich wieder um eine Vorrichtung zur absoluten Positionsbestimmung, die neben einer erfindungsgemäß abgetasteten Inkrementalspur ferner eine seriell codierte Absolutspur aufweist.

Figur 2a zeigt wiederum den prinzipiellen Abtaststrahlengang des zweiten Ausführungsbeispieles der erfindungsgemäßen Positionsmesseinrichtung; die nachfolgend erläuterten Unterschiede zur ersten Variante in der Art und Weise der Inkrementalsignal-Erzeugung sind in dieser Darstellung jedoch nicht erkennbar. Im Gegensatz zum ersten Ausführungsbeispiel aus den Figuren 1a — 1f ist nunmehr nicht mehr vorgesehen, die beiden Inkrementalsignale INC1, INC mit den unterschiedlichen Signalperioden SP1, SP2 über zwei räumlich getrennte Inkrementalsignal-Detktoranordnungen zu erfassen, sondern hierzu eine modifizierte, gemeinsame Inkrementalsignal-Detektoranordnung 240.1 auf Seiten der Detektoreinheit 240 zu verwenden.

In Bezug auf den Abtaststrahlengang zur Erzeugung der Absolutpositionssignale ABS und die Ausbildung der Absolutpositionssignal-Detektoranordnung 240.3 liegen keine Unterschiede zur ersten Variante vor; es sei diesbezüglich deshalb lediglich auf die obigen Erläuterungen verwiesen.

Unterschiede zur oben erläuterten Variante existieren hingegen im Zusammenhang mit verschiedenen Maßnahmen, die in Bezug auf die Erzeugung der verschiedenen Inkrementalsignale INC1, INC2 von Bedeutung sind.

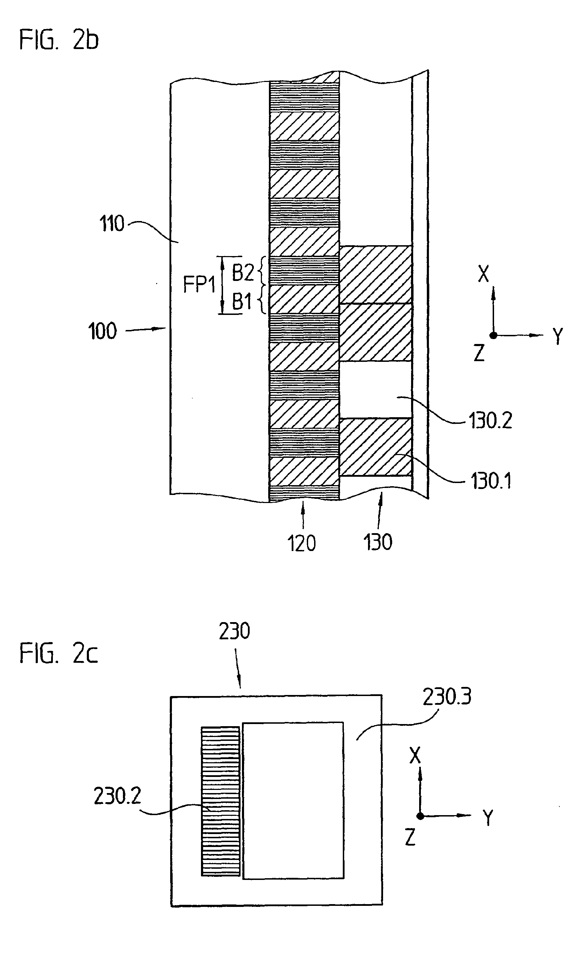

So ist in Figur 2b erkennbar, dass eine etwas modifizierte Ausgestaltung der Inkrementalspur 120 auf dem Maßstab 100 vorliegt, da die Blöcke B1', B2' in dieser Spur in Messrichtung x nunmehr die gleiche Breite aufweisen. Aus der Summe dieser Breiten ergibt sich die grobe Teilungsperiode $TP_1$, die insgesamt jedoch wiederum identisch zur Teilungsperiode $TP_1$ im obigen Beispiel gewählt ist, d.h. $TP_1 = 200\mu m$. Ebenso wie im ersten Ausführungsbeispiel sind die Blöcke B2' strukturiert; hierbei wird innerhalb der Blöcke B2' wiederum die feinere Teilungsperiode gemäß $TP_1 = 20\mu m$ gewählt.

Wie aus Figur 2c ersichtlich, ist auf Seiten der Abtastplatte 230 im Gegensatz zum obigen Beispiel nunmehr nur noch eine einzige Abtastteilung 230.2 neben dem transparenten Fensterbereich 230.3 angeordnet, die in Messrichtung x eine ähnliche Länge aufweist wie der transparente Fensterbereich 230.3. Die Abtastteilung 230.2 ist identisch ausgebildet wie die Abtastteilung 23.2 im obigen Beispiel, die dort lediglich zur Erzeugung des hochauflösenderen Inkrementalsignales INC2 genutzt wurde. Die Abtastteilung 230.2 weist demnach in diesem Beispiel eine Abtastteilungsperiode $ATP_2$ auf, die sich geringfügig von der feineren Teilungsperiode $TP_2 = 20\mu m$ in der Inkrementalspur 120 unterscheidet. Wie die Abtastteilung 23.2 im ersten Ausführungsbeispiel ist die einzige Abtastteilung 230.2 dieser Variante ausgebildet, nämlich als kombinierte Phasen-/Amplitudenstruktur, wie sie der deutschen Patentanmeldung Nr. 199 41 318.5 der Anmelderin vorgeschlagen wurde.

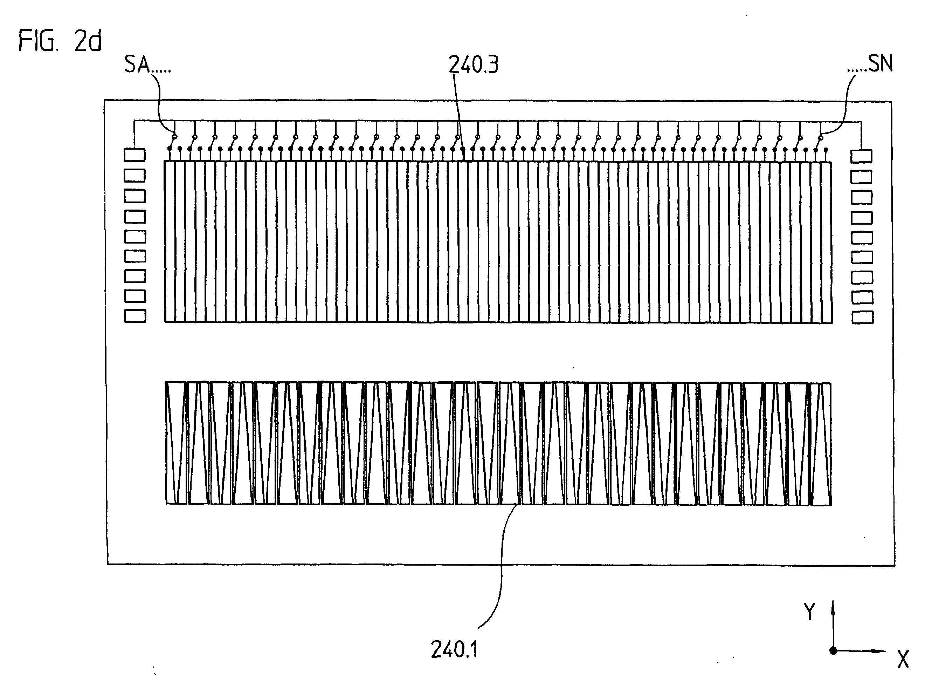

In der Detektionsebene der Detektoreinheit 240 resultiert zur Erzeugung der beiden Inkrementalsignale INC1, INC2 mit den unterschiedlichen Signalperioden $SP_1$, $SP_2$ lediglich ein einziges Vernier-Streifensystem VS' am Ort der Inkrementalsignal-Detektoranordnung 240.1. Wie aus der schematischen Ansicht der Detektionsebene in Figur 2d ersichtlich ist, ist demzufolge lediglich nur noch eine einzige Inkrementalsignal-Detektoranordnung 240.1 vorgesehen, über die das Vernier-Streifenmuster in dieser Ebene zur Erzeugung der beiden Inkrementalsignale INC1, INC2 abgetastet wird.

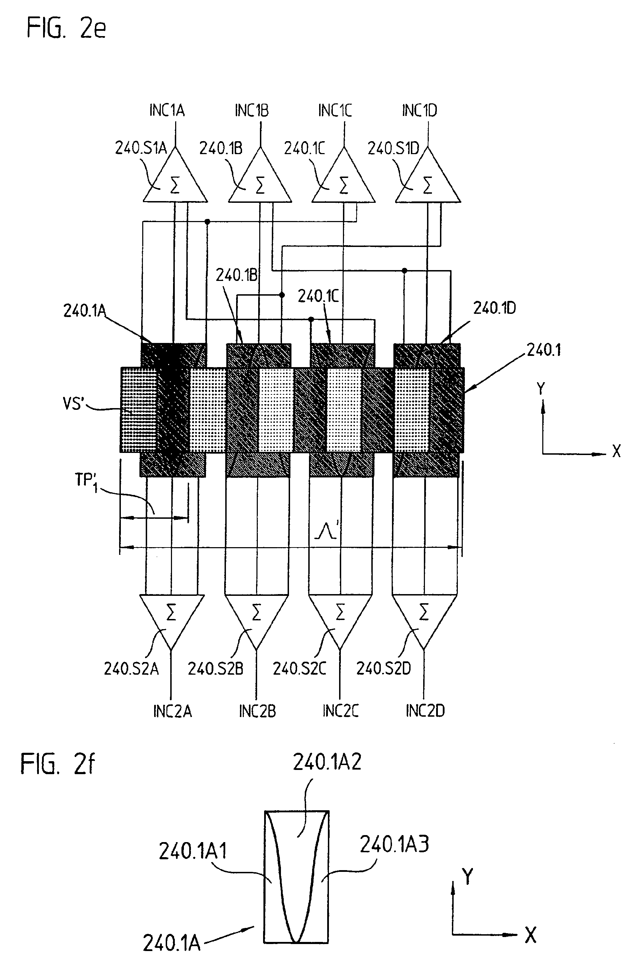

Zur detaillierten Erläuterung der in diesem Beispiel vorgesehenen einzigen Inkrementalsignal-Detektoranordnung 240.1 und der Erzeugung der beiden Inkrementalsignale INC1, INC2 sei auf die Figur 2e verwiesen, die einen Ausschnitt der Inkrementalsignal-Detektoranordnung 240.1 sowie das damit abgetastete Vernier-Streifenmuster VS' zeigt, das die Vernierperiode $\Lambda'$ aufweist. Wie im bereits oben erläuterten Beispiel weist das abgetastete Vernier-Streifenmuster VS' zum einen die Vernier-Periode $\Lambda'$ auf, die letztlich aus der Abtastung der Teilungsperiode $TP_2$ resultiert. Darüberhinaus ist diesem Vernier-Streifenmuster VS' wiederum ein Muster mit einer Periodizität $TP_1$ überlagert, wobei die Periodizität $TP_1$ deutlich kleiner ist als die Vernier-Periode $\Lambda'$.

In Figur 2e ist lediglich ein kleiner Ausschnitt der Inkrementalsignal-Detektoranordnung 240.1 dargestellt, der sich über lediglich eine Vernierperiode $\Lambda'$ erstreckt; in der Praxis ist eine in Messrichtung x sich vielfach wiederholende Abfolge des dargestellten Ausschnittes vorgesehen.

Die in der Inkrementalsignal-Detektoranordnung 240.1 vorgesehenen, periodisch angeordneten Detektorelemente 240.1A,...240.1D weisen in dieser Ausführungsform nunmehr eine innere Strukturierung dergestalt auf, das jedes Detektorelement 240.1A,...240.1D wiederum aus ingesamt drei einzelnen Teil-Detektorelementen 240.1A1, 240.1A2, 240.1A3 besteht, wie dies in Figur 2f für das Detektorelement 240.1A vergrößert dargestellt ist. Die geometrische Form der einzelnen Teil-Detektorelemente 240.1A1, 240.1A2, 240.1A3 ist hierbei dergestalt gewählt, dass darüber eine bestimmte Filterwirkung bei der Abtastung der groben Teilungsperiode $TP_1$ resultiert. Hierzu wird einerseits die Breite jedes Detektorelementes 240.1A, ...240.1D gleich der groben Teilungsperiode $TP_1$ gewählt. Andererseits weisen das innere Teil-Detektorelement 240.1A2 und die Kombinationen der jeweils äußeren Teil-Detektorelemente 240.1A1, 240.1A3 cosinusförmige Begrenzungslinien auf. Die Periode der entsprechenden Cosinusfunktion ist identisch zur groben Teilungsperiode $TP_1$ gewählt.

Das zum Detektorelement 240.1A benachbarte Detektorelement 240.1B besteht ebenfalls aus drei Teil-Detektorelementen, wobei die Anordnung der drei Teil-Detektorelemente in diesem Ausführungsbeispiel um 180° verdreht vorgesehen ist; das nächste Detektorelement 240.1C ist wiederum identisch wie das erste Detektorelement 240.1A ausgebildet, während das dargestellte vierte Detektorelement 240.1D wiederum wie das zweite Detektorelement 240.1B ausgebildet ist.

Über die gewählte Formgebung der Teil-Detektorelemente 240.1A1, 240.1A2, 240.1A3 lässt sich in bekannter Art und Weise eine detektorseitige Filterung unerwünschter Signalanteile bei der Abtastung sicherstellen. Dies ist in diesem Ausführungsbeispiel erforderlich, da im Gegensatz zur vorhergenden Variante nur eine einzige Abtastteilung vorgesehen ist, die keine implizite Filterwirkung aufweist. Wie oben erläutert wurde, ist jedoch zur Erzeugung des groben Inkrementalsignales INC1 eine Filterung des resultierenden Abtastsignales erforderlich, um u.a. Signalanteile zu eliminieren, die auf die feinere Teilungsperiode $TP_2$ in der Inkrementalspur zurückgehen. Während dies im obigen Beispiel durch entsprechende Filterungsmaßnahmen auf Seiten der Abtastteilung 23.1 erfolgte, wird der gleiche Filterungseffekt nunmehr in diesem Beispiel durch die geometrische Ausgestaltung der Teil-Detektorelemente 240.1A1, 240.1A2, 240.1A3 bewirkt.

Selbstverständlich kann dieser gewünschte, detektorseitige Filterungseffekt auch durch alternative Geometrien der Teil-Detektorelemente 240.1A1, 240.1A2, 240.1A3 bewirkt werden. Möglich ist hierbei etwa die mehrfach in y-Richtung aufeinanderfolgende Anordnung derartiger Teil-Detektorelemente etc..

Zur Erzeugung der feinen Teil-Inkrementalsignale INC2A, ....INC2D werden die verschiedenen Teil-Detektorelemente 240.1A1, 240.1A2, 240.1A3 derart miteinander verschaltet wie dies im unteren Teil der Figur 2e dargestellt ist. Dies bedeutet, dass jeweils die Abtastsignale dreier Teil-Detektorelemente 240.1A1, 240.1A2, 240.1A3 eines Detektorelementes 240.1A aufsummiert werden, was mit Hilfe geeigneter Summier-Elemente 240.S1A, ..240.S1D erfolgt. Die an den Ausgängen der Summier-Elemente 240.S1A, ...240.S1D anliegenden feinen Teil-Inkrementalsignale INC2A,......INC2D, die die identischen Phasenbeziehungen aufweisen, werden ebenfalls zusammengeführt und derart aufsummiert, so dass ausgangsseitig letzlich die vier feinen Teil-Inkrementalsignale INC2A,....INC2D mit jeweils 90° Phasenversatz vorliegen, die in bekannter Art und Weise weiterverarbeitbar sind.

Zur Erzeugung der groben Teil-Inkrementalsignale INC1A, ....INC1D erfolgt die Verschaltung der verschiedenen Teil-Detektorelemente 240.1A1, 240.1A2, 240.1A3 der einzelnen Detektorelemente 240,1A,... 240.1 D derart, wie dies im oberen Teil der Figur 2e dargestellt ist. Insbesondere wird durch die gewählte Verschaltung hierbei wiederum eine gleichbleibende Amplitude der resultierenden Inkrementalsignale INC1A,..INC1D sichergestellt. Zu diesem Zweck werden jeweils zur Erzeugung eines ausgangsseitigen Inkrementalsignales INC1A,...INC1D drei gezielt ausgewählte Teil-Detektorelemente zusammengeschaltet bzw. über Summierelemente 240.S2A....240.S2D aufsummiert. So werden etwa zur Erzeugung des Inkrementalsignales INC1A das mittlere Teil-Detektorelement 240.1A2 des Detektorelementes 240.1A und die beiden äußeren Teil-Detektorelemente 240.1C1, 240.1C3 des Detektorelementes 240.1C zusammengeschaltet usw.. Die Auswahl der zusammenzuschaltenden Teil-Detektorelemente erfolgt hierbei unter dem Gesichtspunkt, dass das daraus resultierende Inkrementalsignal INC1 eine gleichbleibende Signalamplitude aufweisen soll. Zu diesem Zweck werden deshalb jeweils drei Teil-Detektorelemente miteinander verschaltet bzw. aufsummiert, die identische Bereiche des Schattenwurfmusters mit der Periode $TP_1$ im Vernier-Streifenmuster VS' erfassen, jedoch an örtlich unterschiedlichen Stellen des Vernier-Streifenmusters VS' auftreten, insbesondere an komplementären ersten und zweiten Stellen des Vernier-Streifenmusters. So erfasst etwa das Teil-Detektorelement 240.1A2 im wesentlichen einen dunklen Bereich des Schattenwurfmusters an einer ersten Stelle des Vernier-Streifenmusters VS'; die beiden Teil-Detektorelemente 240.1C1, 240.1C3 erfassen ebenfalls dunkle Bereiche des Schattenwurfmusters, jedoch an einer zweiten Stelle des Vernier-Streifenmusters, die um eine halbe Vernierstreifenperiode versetzt ist und an der ein komplementäres Vernier-Streifenmuster zur ersten Stelle vorliegt. Analog zu diesen Überlegungen erfolgt auch die Verschaltung der restlichen Teil-Detektorelemente. Durch die Aufsummation der verschiedenen Signale resultiert schließlich die gewünschte Amplitudenkonstanz des ausgangsseitigen groben Inkrementalsignale INC1A,....INC1D.

Wie bereits mehrfach angedeutet ist die vorliegende Erfindung selbstverständlich nicht auf die beiden explizit erläuterten Ausführungsbeispiele beschränkt, d.h. es existieren im Rahmen der vorliegenden Erfindung auch noch alternative Ausführungsvarianten.

So kann etwa vorgesehen werden, andere ganzzahlige Verhältnisse zwischen den Teilungsperioden $TP_1$, $TP_2$ in der Inkrementalspur zu realisieren. Ebenso können selbstverständlich auch andere Verhältnisse zwischen den Teilungsperioden $TP_1$, $TP_2$ der Inkrementalspur und der jeweiligen Bitbreite in der Absolutspur vorzusehen usw..

Desweiteren kann detektorseitig vorgesehen sein, verschiedenste Bauelemente zur Signalverarbeitung bzw. Signalaufbereitung unmittelbar auf dem entsprechenden Trägersubstrat der Detektoranordnung anzuordnen oder zu integrieren; hierbei kann es sich z.B. um Schalter, Triggerstufen, Strom/Spannungswandler etc. handeln.

Ferner kann alternativ zum Vernier-Streifenmuster ebenso vorgesehen werden, in bekannter Art und Weise ein Moiré-Streifenmuster zu erzeugen und abzutasten.

Schließlich ist es auch möglich, im Rahmen der vorliegenden Erfindung nicht nur mit streng kollimierter Beleuchtung, sondern auch mit divergenter Beleuchtung zu arbeiten. In diesem Fall sind bei der Dimensionierung der jeweiligen Detektoranordnung dann zusätzlich zu den oben erläuterten Überlegungen entsprechende Vergrößerungsfaktoren zu beachten.

Desweiteren lassen sich auch alternative Varianten realisieren, die auf der Maßstab-Seite z.B. lediglich eine einzige Inkrementalspur umfassen, die bei der Abtastung zwei Inkrementalsignale unterschiedlicher Periodizität liefert.

**Patentansprüche**

1. Positionsmesseinrichtung, bestehend aus einem Maßstab (10; 100) und einer relativ zum Maßstab (10; 100) in Messrichtung (x) beweglichen Abtasteinheit (20; 200), wobei

   - auf dem Maßstab (10; 100) eine sich in Messrichtung (x) erstreckende Inkrementalspur (13; 130) angeordnet ist, die eine Inkrementalteilung mit zwei unterschiedlichen Teilungsperioden ($TP_1$, $TP_2$) umfasst und
   - die Abtasteinheit (20; 200) eine Inkrementalsignal-Detektoranordnung (24.1, 24.2; 240.1) umfasst, wobei die Inkrementalsignal-Detektoranordnung (24.1, 24.2; 240.1) zur Erzeugung von Inkrementalsignalen (NC1) mit einer ersten, groben Signalperiode (SP1) sowie zur Erzeugung von Inkrementalsignalen (INC2) mit einer zweiten, feinen Signalperiode (SP2) geeignet ist.

2. Positionsmesseinrichtung nach Anspruch 1, wobei

   - auf dem Maßstab (10; 100) ferner eine Absolut-Spur (12; 120) parallel zur Inkrementalspur (13; 130) angeordnet ist und die Absolut-Spur (12; 120) eine Absolutcodierung umfasst und
   - die Abtasteinheit (20; 200) ferner eine Absolutpositionssignal-Detektoranordnung (24.3; 240.3) zur Erzeugung eines Absolutpositionssignales (ABS) aufweist.

3. Positionsmesseinrichtung nach Anspruch 1, wobei die Inkremental-Spur (13; 130) auf dem Maßstab (10; 100) eine erste Inkrementalteilung mit einer groben Teilungsperiode ($TP_1$) und eine zweite Inkrementalteilung mit einer feinen Teilungsperiode ($TP_2$) aufweist und die Teilungsperioden ($TP_1$, $TP_2$) in einem ganzzahligen Verhältnis zueinander stehen.

4. Positionsmesseinrichtung nach Anspruch 3, wobei die Inkremental-Spur (13; 130) auf dem Maßstab (10; 100) in Messrichtung (x) periodisch aufeinanderfolgende erste und zweite Blöcke (B1, B2) umfasst, die im Raster der groben Teilungsperiode ($TP_1$) angeordnet sind.

5. Positionsmesseinrichtung nach Anspruch 4, wobei die zweiten Blöcke (B2) jeweils in Messrichtung (x) periodisch aufeinanderfolgende Teilbereiche (12.1, 12.2) mit unterschiedlichen optischen Eigenschaften umfassen, die im Raster der feinen Teilungsperiode (TP$_2$) angeordnet sind.

6. Positionsmesseinrichtung nach Anspruch 5, wobei die ersten Blöcke (B1) optisch hochreflektierend oder geringreflektierend ausgebildet sind und die Teilbereiche (12.1, 12.2) in den zweiten Blöcken (B2) alternierend optisch hochreflektierend und geringreflektierend ausgebildet sind.

7. Positionsmesseinrichtung nach Anspruch 5, wobei die verschiedenen Teilbereiche (12.1, 12.2) in den zweiten Blöcken (B2) derart angeordnet sind, dass über alle Blöcke (B1, B2) entlang der Messrichtung (x) stets sichergestellt ist, dass Teilbereiche (12.1, 12.2) mit unterschiedlichen optischen Eigenschaften alternierend angeordnet sind.

8. Positionsmesseinrichtung nach Anspruch 3, wobei die Absolut-Spur (12; 120) auf dem Maßstab (10; 100) als serielle Code-Struktur ausgebildet ist, die eine Bitbreite aufweist, die der groben Teilungsperiode (TP$_1$) der ersten Inkrementalteilung entspricht.

9. Positionsmesseinrichtung nach Anspruch 2, wobei die Absolutpositionssignal-Detektoranordnung (24.3; 240.3) eine Vielzahl von in Messrichtung (x) benachbarten, jeweils gleich ausgebildeten Detektorelementen (24.3A, 24.3N) umfasst und je zwei oder mehreren, einer Bitbreite zugeordneten benachbarten Detektorelementen (24.3A, 24.3N) ein Schaltelement (SA, SN) zugeordnet ist, über das ein selektives Auslesen jeweils eines Detektorelementes (24.3A, 24.3N) möglich ist.

10. Positionsmesseinrichtung nach Anspruch 2, wobei die Abtasteinheit (20; 200) ferner eine Lichtquelle (21; 210) sowie eine Abtastplatte (23; 230) mit einer oder mehreren Abtastteilungen (23.1, 23.2; 230.2) und einem transparenten Fensterbereich (23.3; 230.3) umfasst.

11. Positionsmesseinrichtung nach Anspruch 3 und 10, wobei die Abtastplatte (20) eine erste und eine zweite Abtastteilung (23.1, 23.2) mit unterschiedlichen Abtastteilungsperioden (ATP$_1$, ATP$_2$) aufweist, die auf die grobe und die feine Teilungsperiode (TP$_1$, TP$_2$) der beiden Inkrementalteilungen abgestimmt sind, so dass in der Detektionsebene jeweils Vernier-Streifenmuster (VS) resultieren.

12. Positionsmesseinrichtung nach Anspruch 11, wobei die erste Abtastteilung (23.1) auf die grobe Inkrementalteilung abgestimmt ist und als reine Amplitudenstruktur ausgebildet ist und die zweite Abtastteilung (23.2) auf die feine Inkrementalteilung abgestimmt ist und als kombinierte Phasen-Amplitudenstruktur ausgebildet ist.

13. Positionsmesseinrichtung nach Anspruch 12, wobei die erste Abtastteilung (23.1) derart ausgebildet ist, dass darüber eine Filterung unerwünschter Signalanteile, insbeondere derjenigen Signalanteile mit der feinen Signalperiode (SP2) resultiert.

14. Positionsmesseinrichtung nach Anspruch 11, wobei die Inkrementalsignal-Detektoranordnung (24.1, 24.2) eine erste und eine zweite Inkrementalsignal-Detektoranordnung (24.1, 24.2) umfasst, die räumlich getrennt voneinander angeordnet sind und die beiden Inkrementalsignal-Detektoranordnungen (24.1, 24.2) jeweils als strukturierte Detektoranordnung ausgebildet sind, welche aus einer Vielzahl einzelner Detektorelemente (24.1 A,..24.1 D, 24.2A,.. 24.2D) bestehen, die in Messrichtung (x) benachbart zueinander angeordnet sind und in jeder Inkrementalsignal-Detektoranordnung (24.1, 24.2) diejenigen Detektorelemente (24.1A,..24.1D, 24.2A,..24.2D) miteinander verschaltet sind, die phasengleiche Ausgangssignale liefern.

15. Positionsmesseinrichtung nach Anspruch 14, wobei jedes fünfte Detektorelement (24.1A...24.1D, 24.2A,..24.2D) miteinander verschaltet ist, so dass pro Inkrementalsignal-Detektoranordnung (24.1, 24.2) vier Teil-Inkrementalsignale (INC1A,..INC1D, INC2A,...INC2D) resultieren, die jeweils einen Phasenversatz von 90° zueinander aufweisen.

16. Positionsmesseinrichtung nach Anspruch 14, wobei die Breite b$_{DET}$ eines Detektorelementes (24.2A,.. 24.2D) in Messrichtung (x) gemäß

$$b_{DET} = n * TP_1$$

gewählt ist, mit n = 1, 2, 3, .... und TP$_1$ := grobe Teilungsperiode der Inkrementalteilungsspur.

17. Positionsmesseinrichtung nach Anspruch 11, wobei das Vernier-Streifenmuster (VS) eine Vernier-Periode A aufweist, die gemäß

$$\Lambda = (2 * m + 1) * TP_1$$

gewählt ist mit m = 1, 2, 3,.... und TP$_1$ := grobe Teilungsperiode der Inkrementalteilungsspur.

18. Positionsmesseinrichtung nach Anspruch 3 und 10, wobei die Abtastplatte (230) eine einzige Abtastteilung (230.2) aufweist, die auf die feine Teilungspe-

riode (TP$_2$) der beiden Inkrementalteilungen abgestimmt ist, so dass in der Detektionsebene ein Vernier-Streifenmuster VS' mit der Vernier-Periode A' resultiert.

19. Positionsmesseinrichtung nach Anspruch 18, wobei die Abtastteilung (230.2) als kombinierte Phasen-Amplitudenstruktur ausgebildet ist.

20. Positionsmesseinrichtung nach Anspruch 18, wobei die Inkrementalsignal-Detektoranordnung (240.1) eine einzige Inkrementalsignal-Detektoranordnung (240.1) umfasst, die als strukturierte Detektoranordnung ausgebildet ist, welche aus einer Vielzahl einzelner Detektorelemente (240.1A,...240.1D) besteht, die in Messrichtung (x) benachbart zueinander angeordnet sind.

21. Positionsmesseinrichtung nach Anspruch 20, wobei jedes Detektorelement (240.1A,...240.1D) eine innere Strukturierung aufweist und aus mehreren Teil-Detektorelementen (240.1A1, 240.1A2, 240.1A3) besteht, deren geometrische Form derart gewählt ist, dass darüber eine definierte Filterwirkung resultiert.

22. Positionsmesseinrichtung nach Anspruch 18, wobei die Breite b$_{DET}$ eines Detektorelementes (241.2A,... 241.2D) in Messrichtung (x) gemäß

$$b_{DET} = n * TP_1$$

gewählt ist, mit n = 1, 2, 3, .... und TP$_1$ := grobe Teilungsperiode der Inkrementalteilungsspur.

23. Positionsmesseinrichtung nach Anspruch 18, wobei eine Vernier-Periode A' gemäß

$$\Lambda' = (2 * m + 1) * TP_1$$

gewählt ist mit m = 1, 2, 3,.... und TP$_1$ := grobe Teilungsperiode der Inkrementalteilungsspur.

24. Positionsmesseinrichtung nach Anspruch 21, wobei zur Erzeugung der feinen Inkrementalsignale (INC2) die drei Teil-Detektorelemente (240.1A1, 240.1A2, 240.1A3) eines Detektorelementes (240.1A) über ein Summier-Element (240.S2A, 240.S2B, 240.S2C, 240.S2D) zusammengeschaltet sind.

25. Positionsmesseinrichtung nach Anspruch 21, wobei zur Erzeugung der groben Inkrementalsignale (INC1) je drei Teil-Detektorelemente verschiedener Detektorelemente (204.1 A, 240.1 B, 240.1C, 240.1 D) über ein Summier-Element (240.S2A, 240.S2B, 240.S2C, 240.S2D) zusammengeschaltet sind und die Auswahl der jeweiligen Teil-Detektorelemente derart erfolgt, dass das resultierende grobe Inkrementalsignal eine gleichbleibende Signalamplitude aufweist.

**Claims**

1. Position measuring device comprising a scale (10; 100) and a scanning unit (20; 200) movable in measurement direction (x) relative to the scale (10; 100), wherein

   • an incremental track (13; 130), which extends in measurement direction (x) and comprises an incremental graduation with two different graduation periods (TP$_1$, TP$_2$), is arranged on the scale (109; 100), and
   • the scanning unit (20; 200) comprises an incremental signal detector assembly (24.1, 24.2; 240.1), wherein the incremental signal detector assembly (24.1, 24.2; 240.1) is suitable for generating incremental signals (NC1) with a first rough signal period (SP1) and also for generating incremental signals (INC2) with a second fine signal period (SP2).

2. Position measuring device according to Claim 1, wherein

   • an absolute track (12; 120) is additionally arranged parallel to the incremental track (13; 130) on the scale (10; 100) and the absolute track (12; 120) comprises an absolute coding, and
   • the scanning unit (20; 200) additionally has an absolute position signal detector assembly (24.3; 240.3) for generating an absolute position signal (ABS).

3. Position measuring device according to Claim 1, wherein the incremental track (13; 130) on the scale (10; 100) has a first incremental graduation with a rough graduation period (TP$_1$) and a second incremental graduation with a fine graduation period (TP$_2$), and the graduation periods (TP$_1$, TP$_2$) are in a whole-number relationship to one another.

4. Position measuring device according to Claim 3, wherein the incremental track (13; 130) on the scale (10; 100) comprises first and second blocks (B1, B2) that are periodically consecutive? in measurement direction (x) and are arranged in the grid of the rough graduation period (TP$_1$).

5. Position measuring device according to Claim 4, wherein the second blocks (B2) respectively comprise sub-regions (12.1, 12.2) with different optical properties that are periodically consecutive in the measurement direction (x) and are arranged in the grid of the fine graduation period ($TP_2$).

6. Position measuring device according to Claim 5, wherein the first blocks (B1) are configured to be optically highly reflective or low reflective and the sub-regions (12.1, 12.2) in the second blocks (B2) are alternately configured to be optically highly reflective and low reflective.

7. Position measuring device according to Claim 5, wherein the different sub-regions (12.1, 12.2) in the second blocks (B2) are arranged in such a manner that it is constantly assured over all blocks (B1, B2) in the measurement direction (x) that sub-regions (12.1, 12.2) with different optical properties are arranged alternately.

8. Position measuring device according to Claim 3, wherein the absolute track (12; 120) on the scale (10; 100) is configured as a serial code structure, which has a bit width corresponding to the rough graduation period ($TP_1$) of the first incremental graduation.

9. Position measuring device according to Claim 2, wherein the absolute position signal detector assembly (24.3; 240.3) comprises a plurality of adjacent detector elements (24.3A, 24.3N) in the measurement direction (x) of respectively identical configuration, and each two or more adjacent detector elements (24.3A, 24.3N) allocated to one bit width have an associated switching element (SA, SN), by means of which a selective readout of a respective detector element (24.3A, 24.3N) is possible.

10. Position measuring device according to Claim 2, wherein the scanning unit (20; 200) additionally comprises a light source (21; 210) as well as a scanning plate (23; 230) with one or more scanning graduations (23.1, 23.2; 230.2) and a transparent window region (23.3; 230.3).

11. Position measuring device according to Claim 3 and 10, wherein the scanning plate (20) has a first and a second scanning graduation (23.1, 23.2) with different scanning graduation periods ($ATP_1$, $ATP_2$), which are matched to the rough and the fine graduation periods ($TP_1$, $TP_2$) of the two incremental graduations, so that vernier stripe patterns (VS) respectively result in the detector plane.

12. Position measuring device according to Claim 11, wherein the first scanning graduation (23.1) is matched to the rough incremental graduation and is configured as a pure amplitude structure, and the second scanning graduation (23.2) is matched to the fine incremental graduation and is configured as a combined phase-amplitude structure.

13. Position measuring device according to Claim 12, wherein the first scanning graduation (23.1) is configured such that a filtering of unwanted signal components, in particular those signal components with the fine signal period (SP2), results from this.

14. Position measuring device according to Claim 11, wherein the incremental signal detector assembly (24.1, 24.2) comprises a first and a second incremental detector assembly (24.1, 24.2), which are arranged to be spatially separated from one another, and the two incremental detector assemblies (24.1, 24.2) are respectively configured as a structured detector assembly, which consist of a plurality of individual detector elements (24.1 A, ..24.1 D, 24.2A,..24.2D), which are arranged adjacent to one another in the measurement direction (x), and those detector elements (24.1 A, ..24.1 D, 24.2A,..24.2D) that deliver in-phase output signals are connected to one another in each incremental signal detector assembly (24.1, 24.2).

15. Position measuring device according to Claim 14, wherein each fifth detector element (24.1A, ..24.1D, 24.2A,..24.2D) is connected to each other, so that for each incremental signal detector assembly (24.1, 24.2) four incremental component signals (INC1A,..INC1D, INC2A,..INC2D) result that respectively have a phase shift of 90° relative to one another.

16. Position measuring device according to Claim 14, wherein the width $b_{DET}$ of a detector element (24.2A,..24.2D) in the measurement direction (x) is selected on the basis of

$$b_{DET} = n * TP_1$$

where n = 1, 2, 3, ... and $TP_1$:= rough graduation period of the incremental graduation track.

17. Position measuring device according to Claim 11, wherein the vernier strip pattern (VS) has a vernier period $\Lambda$, which is selected on the basis of

$$\Lambda = (2 * m + 1) * TP_1$$

where m = 1, 2, 3, ... and $TP_1$:= rough graduation period of the incremental graduation track.

18. Position measuring device according to Claim 3 and 10, wherein the scanning plate (230) has a single scanning graduation (230.2) which is matched to the fine graduation period ($TP_2$) of the two incremental graduations, so that a vernier stripe pattern VS' with the vernier period $\Lambda$' results in the detection plane.

19. Position measuring device according to Claim 18, wherein the scanning graduation (230.2) is configured as a combined phase-amplitude structure.

20. Position measuring device according to Claim 18, wherein the incremental signal detector assembly (240.1) comprises a single incremental signal detector assembly (240.1), which is configured as a structured detector assembly, which consists of a plurality of individual detector elements (240.1 A, ..240.1 D), which are arranged adjacent to one another in the measurement direction (x).

21. Position measuring device according to Claim 20, wherein each detector element (240.1A, ..240.1D) has an internal structure and consists of several component detector elements (240.1A1, 240.1A2, 240.1 A3), the geometric form of which is selected such that a defined filtering effect results from this.

22. Position measuring device according to Claim 18, wherein the width $b_{DET}$ of a detector element (241.2A,..241.2D) in the measurement direction (x) is selected on the basis of

$$b_{DET} = n * TP_1$$

where n = 1, 2, 3,... and $TP_1$:= rough graduation period of the incremental graduation track.

23. Position measuring device according to Claim 18, wherein the vernier period $\Lambda$' is selected on the basis of

$$\Lambda' = (2 * m + 1) * TP_1$$

where m = 1, 2, 3, ... and $TP_1$:= rough graduation period of the incremental graduation track.

24. Position measuring device according to Claim 21, wherein for generation of the fine incremental signals (INC2) the three component detector elements (240.1 A 1, 240.1 A2, 240.1 A3) of a detector element (240.1 A) are switched together by means of an adding element (240.S2A, 240.S2B, 240.S2C, 240.S2D).

25. Position measuring device according to Claim 21, wherein for generation of the rough incremental signals (INC1) three component detector elements of different detector elements (240.1A, 240.1B, 240.1C, 240.1D) are respectively switched together by means of an adding element (240.S2A, 240.S2B, 240.S2C, 240.S2D), and the selection of the respective component detector elements occurs in such a way that the resulting rough incremental signal has a constant signal amplitude.

## Revendications

1. Dispositif de mesure de position consistant en une règle de mesure (10; 100) et une unité de balayage (20; 200) déplaçable par rapport à la règle de mesure (10; 100), dans la direction de mesure (x), dans lequel

- il est prévu sur la règle de mesure (10; 100), une piste incrémentale (13; 130) qui s'étend dans la direction de mesure (x) et comporte une graduation incrémentale avec deux périodes de division ($TP_1$), $TP_2$) différentes, et
- l'unité de balayage (20; 200) comprend un système de détecteurs de signal incrémental (24.1, 24.2; 240.1) qui est adapté pour produire des signaux incrémentaux (NC1) avec une première période de signal grossière (SP1) et pour produire des signaux incrémentaux (INC2) avec une deuxième période de signal fine (SP2).

2. Dispositif de mesure de position selon la revendication 1, dans lequel

- il est également prévu sur la règle de mesure (10; 100), une piste absolue (12; 120) qui est disposée parallèlement à la piste incrémentale (13; 130) et présente un codage absolu, et
- l'unité de balayage (20; 200) présente en outre un système de détecteurs de signal de position absolue (24.3; 240.3), destiné à produire un signal de position absolue (ABS).

3. Dispositif de mesure de position selon la revendication 1, dans lequel la piste incrémentale (13; 130) de la règle de mesure (10; 100) présente une première graduation incrémentale avec une période de division grossière ($TP_1$) et une deuxième graduation incrémentale avec une période de division fine ($TP_2$) et les périodes de division ($TP_1$), $TP_2$) se situent dans un rapport de nombres entiers.

**4.** Dispositif de mesure de position selon la revendication 3, dans lequel la piste incrémentale (13; 130) de la règle de mesure (10; 100) comporte des premiers et des deuxièmes blocs (B1, B2) qui se succèdent périodiquement dans la direction de mesure (x) et sont disposés dans le réseau de la période de division grossière (TP$_1$).

**5.** Dispositif de mesure de position selon la revendication 4, dans lequel les deuxièmes blocs (B2) comportent des zones partielles (12.1, 12.2) qui se succèdent périodiquement dans la direction de mesure (x), présentent des propriétés optiques différentes et sont disposées dans le réseau de la période de division fine (TP$_2$).

**6.** Dispositif de mesure de position selon la revendication 5, dans lequel les premiers blocs (B1) sont réalisés de manière à être fortement réfléchissants ou faiblement réfléchissants sur le plan optique, et les zones partielles (12.1, 12.2) des deuxièmes blocs (B2) sont réalisées de manière à être en alternance fortement réfléchissantes ou faiblement réfléchissantes sur le plan optique.

**7.** Dispositif de mesure de position selon la revendication 5, dans lequel les différentes zones partielles (12.1, 12.2) dans les deuxièmes blocs (B2) sont disposées de manière à garantir toujours pour tous les blocs (B1, B2) le long de la direction de mesure (x) que des zones partielles (12.1, 12.2) avec des propriétés optiques différentes soient disposées en alternance.

**8.** Dispositif de mesure de position selon la revendication 3, dans lequel la piste absolue (12; 120) de la règle de mesure (10; 100) est réalisée comme structure codée sérielle présentant une largeur en bits qui correspond à la période de division grossière (TP$_1$) de la première graduation incrémentale.

**9.** Dispositif de mesure de position selon la revendication 2, dans lequel le système de détecteurs de signal de position absolue (24.3; 240.3) comporte une pluralité de détecteurs élémentaires (24.3A, 24.3N) de structure identique, disposés les uns à côté des autres dans la direction de mesure (x), et un élément de commutation (SA, SN) est associé à deux ou plusieurs détecteurs élémentaires (24.3A, 24.3N) voisins, associés à une largeur en bits, et permet d'effectuer une lecture sélective chaque fois d'un détecteur élémentaire (24.3A, 24.3N).

**10.** Dispositif de mesure de position selon la revendication 2, dans lequel l'unité de balayage (20; 200) comprend en outre une source lumineuse (21; 210) ainsi qu'une plaque de balayage (23; 230) avec une ou plusieurs graduations de balayage (23.1, 23.2;

230.2) et une zone de fenêtre transparente (23.3; 230.3).

**11.** Dispositif de mesure de position selon les revendications 3 et 10, dans lequel la plaque de balayage (20) présente une première et une deuxième graduation de balayage (23.1, 23.2) avec des périodes de division de balayage 1(ATP$_1$, ATP$_2$) différentes, qui sont accordées avec les périodes de division grossière et fine (TP$_1$, TP$_2$) des deux graduations incrémentales, de sorte qu'il en résulte respectivement des motifs de franges vernier (VS) dans le plan de détection.

**12.** Dispositif de mesure de position selon la revendication 11, dans lequel la première graduation de balayage (23.1) est accordée avec la graduation incrémentale grossière et est agencée comme structure d'amplitude pure, et la deuxième graduation de balayage (23.2) est accordée avec la graduation incrémentale fine et est agencée comme structure combinée de phase-amplitude.

**13.** Dispositif de mesure de position selon la revendication 12, dans lequel la première graduation de balayage (23.1) est agencée de manière telle qu'il en résulte un filtrage des fractions de signal indésirables, notamment des fractions de signal présentant la période de signal fine (SP2).

**14.** Dispositif de mesure de position selon la revendication 11, dans lequel le système de détecteurs de signal incrémental (24.1, 24.2) comprend un premier et un deuxième système de détecteurs de signal incrémental (24.1, 24.2), qui sont séparés l'un de l'autre dans l'espace, et les deux systèmes de détecteurs de signal incrémental (24.1, 24.2) sont chacun agencés sous forme de système de détecteurs structuré, constitué d'une pluralité de détecteurs élémentaires (24.1A,...24.1D, 24.2A,...24.2D) individuels, disposés les uns à côté des autres dans la direction de mesure (x), et dans chaque système de détecteurs de signal incrémental (24.1, 24.2), sont interconnectés ceux des détecteurs élémentaires (24.1A,...24.1D, 24.2A,...24.2D) qui fournissent des signaux de sortie de même phase.

**15.** Dispositif de mesure de position selon la revendication 14, dans lequel tous les cinquièmes détecteurs élémentaires (24.1A,...24.1D, 24.2A,...24.2D) sont interconnectés, de sorte qu'il en résulte pour chaque système de détecteurs de signal incrémental (24.1, 24.2) quatre signaux incrémentaux partiels (INC1A,...INC1D, INC2A,...INC2D) qui présentent un déphasage réciproque de 90°.

**16.** Dispositif de mesure de position selon la revendication 14, dans lequel la largeur b$_{DET}$ d'un détecteur élémentaire (24.2A, ...24.2D), dans la direction de mesure (x), est choisie selon

$$b_{DET} = n * TP_1$$

avec n = 1, 2, 3, ... et $TP_1$ := période de division grossière de la piste de graduation incrémentale.

**17.** Dispositif de mesure de position selon la revendication 11, dans lequel le motif de franges vernier (VS) présente une période vernier A qui est choisie selon

$$\Lambda = (2 * m + 1) * TP_1$$

avec m = 1, 2, 3, ... et $TP_1$ := période de division grossière de la piste de graduation incrémentale.

**18.** Dispositif de mesure de position selon les revendications 3 et 10, dans lequel la plaque de balayage (230) présente une graduation de balayage (230.2) unique qui est accordée avec la période de division fine ($TP_2$) des deux graduations incrémentales, de sorte qu'il en résulte un motif de franges vernier VS' avec la période vernier A' dans le plan de détection.

**19.** Dispositif de mesure de position selon la revendication 18, dans lequel la graduation de balayage (230.2) est agencée comme structure combinée de phase-amplitude.

**20.** Dispositif de mesure de position selon la revendication 18, dans lequel le système de détecteurs de signal incrémental (240.1) comprend un système de détecteurs de signal incrémental (240.1) unique qui est agencé sous forme de système de détecteurs structuré, constitué d'une pluralité de détecteurs élémentaires (240.1 A, ...240.1 D) individuels, disposés les uns à côté des autres dans la direction de mesure (x).

**21.** Dispositif de mesure de position selon la revendication 20, dans lequel chaque détecteur élémentaire (240.1A,...240.1D) présente une structure interne et se compose de plusieurs détecteurs élémentaires partiels (240.1A1, 240.1A2, 240.1A3) dont la forme géométrique est choisie telle qu'il en résulte un effet de filtrage défini.

**22.** Dispositif de mesure de position selon la revendication 18, dans lequel la largeur $b_{DET}$ d'un détecteur élémentaire (241.2A, ...241.2D), dans la direction de mesure (x), est choisie selon

$$b_{DET} = n * TP_1$$

avec n = 1, 2, 3, ... et $TP_1$ := période de division grossière de la piste de graduation incrémentale.

**23.** Dispositif de mesure de position selon la revendication 18, dans lequel une période vernier A' est choisie selon

$$\Lambda' = (2 * m + 1) * TP_1$$

avec m = 1, 2, 3, ... et $TP_1$ := période de division grossière de la piste de graduation incrémentale.

**24.** Dispositif de mesure de position selon la revendication 21, dans lequel, pour produire les signaux incrémentaux fins (INC2), les trois détecteurs élémentaires partiels (240.1A1, 240.1A2, 240.1A3) d'un détecteur élémentaire (240.1A) sont interconnectés via un élément additionneur (240.S2A, 240.S2B, 240.S2C, 240.S2D).

**25.** Dispositif de mesure de position selon la revendication 21, dans lequel, pour produire les signaux incrémentaux grossiers (INC1), trois détecteurs élémentaires partiels de différents détecteurs élémentaires (240.1A, 240.1B, 240.1C, 240.1D) sont interconnectés via un élément additionneur (240.S2A, 240.S2B, 240.S2C, 240.S2D), et la sélection des détecteurs élémentaires partiels respectifs se fait de manière telle que le signal incrémental grossier résultant présente une amplitude de signal constante.

FIG. 1a

EP 1 111 345 B1

FIG. 1b

11

TP$_1$ { B2 {
{ B1 {

10 →

Fig. 1c

X
Z Y

13.2

13.1

12        13

FIG. 1c

FIG. 1d

FIG. 1e

SA.....

24.3

.....SN

24.3K

24.3A

INC2A

INC1B

INC2C

INC1D

24.2

24.1

INC1A

INC2D

INC1C

INC2B

24.1A  24.1B 24.1C  24.1D

24 24.2A  24.2D  24.2B 24.2C

Y

Z  X

EP 1 111 345 B1

FIG. 1f

VS

24.1A  24.1B  24.1C  24.1D

FIG. 1g

SP1          SP2

FIG. 2a

FIG. 2b

110

FP1 $\left\{\begin{array}{l} B2 \\ B1 \end{array}\right.$

100

X

Y

Z

130.2

130.1

120    130

FIG. 2c

230

230.3

230.2

X

Y

Z

FIG. 2d

## FIG. 2e

INC1A     INC1B     INC1C     INC1D

240.S1A    240.1B    240.1C    240.S1D

$\Sigma$    $\Sigma$    $\Sigma$    $\Sigma$

240.1B

240.1C

240.1A             240.1D

240.1

VS'

Y

X

TP'$_1$

$\Lambda'$

$\Sigma$    $\Sigma$    $\Sigma$    $\Sigma$

240.S2A    240.S2B    240.S2C    240.S2D

INC2A     INC2B     INC2C     INC2D

## FIG. 2f

240.1A2

240.1A1           240.1A3

Y

X

240.1A

**EP 1 111 345 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5252825 A
- DE 19505176 A1
- DE 19941318
- GB 2116313 A